# EUROPEAN PATENT APPLICATION

(11) **EP 1 452 574 A1**
(43) Date of publication of application: **01.09.2004**
(21) Application number: 02781866.5
(22) Date of filing: 02.12.2002
(51) Int. Cl.: C09K 11/06, H05B 33/14

(54) **COMPOSITION FOR ORGANIC ELECTROLUMINESCENCE ELEMENT AND ORGANIC ELECTROLUMINESCENCE ELEMENT USING THE SAME**

(30) Priority: 03.12.2001 JP 2001368036; 28.01.2002 JP 2002018009
(71) Applicant: TOYO INK MFG. CO., LTD., Chuo-ku Tokyo 1040-0031 (JP)
(72) Inventor: ONIKUBO, Toshikazu, c/o Toyo Ink Mfg. Co., Ltd., Chuo-ku, Tokyo 104-8377 (JP); ORYU, Yoshitake, c/o Toyo Ink Mfg. Co., Ltd., Chuo-ku, Tokyo 104-8377 (JP); AMANO, Masaomi, c/o Toyo Ink Mfg. Co., Ltd., Chuo-ku, Tokyo 104-8377 (JP); MAKI, Shinichiro, c/o Toyo Ink Mfg. Co., Ltd., Chuo-ku, Tokyo 104-8377 (JP); YANAI, Hiroyuki c/o Toyo Ink Mfg. Co., Ltd., Chuo-ku, Tokyo 104-8377 (JP); YAGI, Tadao, c/o Toyo Ink Mfg. Co., Ltd., Chuo-ku, Tokyo 104-8377 (JP)
(74) Representative: Koepe, Gerd L., Dipl.-Chem.
(86) International application number: PCT/JP2002/012592
(87) International publication number: WO 2003/048268

(57) **Abstract**

There are disclosed an organic electroluminescent (EL) device composition that includes a compound (A) having a perylene ring and a compound (B) having a diketopyrrolopyrrole skeleton, and an organic EL device that includes a pair of electrodes consisting of an anode and a cathode, and one or more organic, layers including a light-emitting layer formed between the electrodes, at least one of the organic layers being a layer formed from the organic EL device composition. Furthermore, there are disclosed an organic EL device composition that includes a compound (C) having, as a solid film, a fluorescence spectrum peak wavelength of 550 nm or longer, and a compound (D) having, as a solid film in which Compound (D) is contained at 5 wt% in Compound (C), an area at a wavelength of 600 nm or shorter in a fluorescence spectrum region of 500 to 800 nm of 20% or less of the entire area, and an organic EL device including a light-emitting layer formed from this composition.

## Description

### Technical Field

The present invention relates to an organic electroluminescent (EL) device composition (material for an organic EL device) and an organic EL device employing same, the composition and device being used in flat light sources. displays, etc.

### Background Art

The application of EL devices employing organic materials as inexpensive solid-state light-emitting, large-area full color display devices is promising, and they have been developed actively. In general, an EL device is formed from a light-emitting layer and a pair of opposing electrodes having the layer sandwiched therebetween. When an electric field is applied between the two electrodes, electrons are injected from the cathode side, and holes are injected from the anode side. When the electrons recombine with the holes in the light-emitting layer, their energy level returns from a conduction band to a valence band, and the energy is released as light. This phenomenon is called luminescence.

Compared with inorganic EL devices, conventional organic EL devices require a high drive voltage, their luminance and luminescence efficiency are low, and their properties easily deteriorate; they have therefore not been put into practical use. However, recently, an organic EL device having a formed thin film containing an organic compound having a high fluorescence quantum efficiency such that light emission occurs at a low voltage of 10 V or less has been reported and is attracting much attention (ref. Appl. Phys. Lett., Vol. 51, p. 913, 1987). In accordance with this method, high intensity green luminescence can be obtained by the use of a metal chelate complex in a light-emitting layer and an amine compound in a hole injection layer, a luminance of a few of thousands (cd/m²) at a dc voltage of 6 to 10 V and a maximum luminescence efficiency of 1.5 (lm/W) have been achieved, and the performance is close to a practical level.

Among the organic EL devices, with regard to organic EL device luminescent materials for obtaining, in particular, orange to red luminescence, 4H-pyran derivatives such as DCM, DCJ, DCJT, and DCJTB described in C. H. Chen et al., Macromol. Symp., No. 125, pp. 34-36 and 49-58, 1997, have been reported, but they have the problem of low luminance.

None of the conventional organic EL device luminescent materials for obtaining high intensity orange to red luminescence thus have sufficient luminance, and their lifetime is short. On the other hand, since yellow to red luminescent materials have molecular structures that are highly planar and, furthermore are highly polar, with an electron-donating portion and an electron-withdrawing portion in the molecule so as to exhibit long wavelength fluorescence, when they are used as organic EL device luminescent materials, undesirable phenomena such as 'concentration quenching' in which excited molecules of the same kind interact with each other and are deactivated without emitting light easily occur. Attempts at improvement have been made by increasing the number of substituents, introducing a sterically bulky substituent, etc., but there is a concern that the accompanying increase in the molecular weight might degrade the solvent solubility or that there might be a deterioration in the workability, such as a deterioration in the vapor deposition properties during device fabrication. There has therefore been a desire for an organic EL device material that has higher luminance and a longer lifetime without causing any deterioration in the workability.

In order to achieve both high luminance and long lifetime, a technique called doping is employed, and it is an important object to find a good combination of a host material, which is a main component of a film, and a doping material (dopant), which is a light emitting component.

### Disclosure of Invention

In accordance with a first aspect of the present invention, there is provided an organic EL (electroluminescent) device composition (hereinafter, called 'Composition X') comprising a compound (A) having a perylene ring and a compound (B) having a diketopyrrolopyrrole skeleton.

In accordance with a second aspect of the present invention, there is provided an organic electroluminescent device composition (hereinafter, called 'Composition Y') comprising a compound (C) and a compound (D) having the characteristics below:
(1) Compound (C): a compound having, as a solid film, a fluorescence spectrum peak wavelength of 550 nm or longer;
(2) Compound (D): a compound having, as a solid film in which Compound (D) is contained at 5 wt% in Compound (C). an area at a wavelength of 600 nm or shorter in a fluorescence spectrum region of 500 to 800 nm of 20% or less of the entire area.

In accordance with a third aspect of the present invention, there is provided an organic EL device comprising a pair of electrodes comprising an anode and a cathode, and one or more organic layers comprising a light-emitting layer formed between the electrodes, wherein at least one of the organic layers is a layer formed from the Composition X.

In accordance with a fourth aspect of the present invention, there is provided an organic EL device comprising a pair of electrodes comprising an anode and a cathode, and one or more light-emitting layers formed between the electrodes, wherein at least one of the light-emitting layers is a layer formed from the Composition Y.

### Brief Description of the Drawings

Fig. 1 is a cross sectional view schematically showing one embodiment of the organic EL device.
Fig. 2 is a chart showing a fluorescence spectrum of a thin film having a film thickness of 30 nm that has been vapor-codeposited so that Compound (A4) contains 5 wt% of Compound (B9) (double dotted broken line) and an EL emission spectrum in Example 8 (solid line) (the intensities have been adjusted so that the areas of the spectra are equal).

### Best Mode for Carrying Out the Invention

A Composition X contains a compound (A) having a perylene ring and a compound (B) having a diketopyrrolopyrrole skeleton.

Unsubstituted perylene gives a blue fluorescence, and introducing a substituent shifts the fluorescence wavelength to longer wavelength. When there are a large number of substituents, when a substituent extends the conjugated system, or when a substituent has an electron withdrawing or donating effect, the wavelength shift is large. In particular, when it has an electron-donating group such as an alkoxy group, an aryloxy group, or an amino group, a large wavelength shift can be observed in some cases and, in particular, adding a substituted amino group to the perylene ring enables compounds having strong fluorescence in a wide range of colors from yellow to red, including a target color, to be comparatively easily obtained.

Examples of the substituent added to the perylene ring include a monovalent aliphatic hydrocarbon group, a monovalent aromatic hydrocarbon group, a monovalent aliphatic heterocyclic group, a monovalent aromatic heterocyclic group, a halogen atom. a cyano group, an alkoxyl group, an aryloxy group, an alkylthio group, an arylthio group, an acyl group, an alkoxycarbonyl group, an aryloxycarbonyl group, an alkylsulfonyl group, and an arylsulfonyl group.

Examples of the monovalent aliphatic hydrocarbon group include an alkyl group, an alkenyl group, an alkynyl group, and a cycloalkyl group, which preferably have 1 to 18 carbons. Specific examples thereof include alkyl groups having 1 to 18 carbons such as methyl, ethyl, propyl, isopropyl, butyl, isobutyl, *sec*-butyl, *tert*-butyl, pentyl, isopentyl, hexyl, heptyl, octyl. decyl, dodecyl, pentadecyl, and octadecyl; alkenyl groups having 2 to 18 carbons such as vinyl, 1-propenyl, 2-propenyl, isopropenyl, 1-butenyl, 2-butenyl, 3-butenyl, 1-octenyl, 1-decenyl, and 1-octadecenyl; alkynyl groups having 2 to 18 carbons such as ethynyl, 1-propynyl, 2-propynyl, 1-butynyl, 2-butynyl, 3-butynyl, 1-octynyl, 1-decynyl, and 1-octadecynyl; and cycloalkyl groups having 3 to 18 carbons such as cyclopropyl, cyclobutyl, cyclopentyl, cyclohexyl, cycloheptyl, cyclooctyl, cyclooctadecyl, 2-bornyl, 2-isobornyl, and 1-adamantyl.

Examples of the monovalent aromatic hydrocarbon group include monocyclic, fused ring, and ring assembly monovalent aromatic hydrocarbon groups having 6 to 30 carbons. Specific examples thereof include monovalent monocyclic aromatic hydrocarbon groups having 6 to 30 carbons such as phenyl, *o*-tolyl, *m*-tolyl, *p*-tolyl, 2,4-xylyl, *p*-cumenyl, and mesityl; monovalent fused ring hydrocarbon groups having 10 to 30 carbons such as 1-naphthyl, 2-naphthyl, 1-anthryl, 2-anthryl, 5-anthryl, 1-phenanthryl, 9-phenanthryl, 1-acenaphthyl, 2-azulenyl, 1-pyrenyl, 2-triphenylenyl, 1-pyrenyl, 2-pyrenyl, 1-perylenyl, 2-perylenyl, 3-perylenyl, 2-triphenylenyl, 2-indenyl, 1-acenaphthylenyl, 2-naphthacenyl, and 2-pentacenyl; and monovalent hydrocarbon ring assembly groups having 12 to 30 carbons such as *o*-biphenylyl, *m*-biphenylyl, *p*-biphenylyl, terphenylyl, and 7-(2-naphthyl)-2-naphthyl.

Examples of the monovalent aliphatic heterocyclic group include monovalent aliphatic heterocyclic groups having 3 to 18 carbons such as 3-isochromanyl, 7-chromanyl, and 3-coumarinyl.

Examples of the monovalent aromatic heterocyclic group include monovalent aromatic heterocyclic groups having 3 to 30 carbons such as 2-furyl, 3-furyl, 2-thienyl, 3-thienyl, 2-benzofuryl, 2-benzothienyl, 2-pyridyl. 3-pyridyl, 4-pyridyl, 2-quinolyl, 3-quinolyl, 4-quinolyl, 1-isoquinolyl, 4-quinolyl, and 2-pyrazinyl.

Examples of the halogen atom include a fluorine atom, a chlorine atom, and a bromine atom.

Examples of the alkoxyl group include alkoxyl groups having 1 to 18 carbons such as methoxy, ethoxy, propoxy, butoxy, *tert*-butoxy, octyloxy, *tert*-octyloxy, 2-bornyloxy, 2-isobornyloxy, and 1-adamantyloxy.

Examples of the aryloxy group include aryloxy groups having 6 to 30 carbons such as phenoxy, 4-*tert*-butylphenoxy, 1-naphthyloxy, 2-naphthyloxy, and 9-anthryloxy.

Examples of the alkylthio group include alkylthio groups having 1 to 18 carbons such as methylthio, ethylthio, *tert*-butylthio, hexylthio, and octylthio.

Examples of the arylthio group include arylthio groups having 6 to 30 carbons such as phenylthio, 2-methylphenylthio, and 4-*tert*-butylphenylthio.

Examples of the acyl group include acyl groups having 2 to 18 carbons such as acetyl. propionyl, pivaloyl, cyclohexylcarbonyl, benzoyl, toloyl, anisoyl, and cinnamoyl.

Examples of the alkoxycarbonyl group include alkoxycarbonyl groups having 2 to 18 carbons such as methoxycarbonyl, ethoxycarbonyl, and benzyloxycarbonyl.

Examples of the aryloxycarbonyl group include aryloxycarbonyl groups having 2 to 18 carbons such as phenoxycarbonyl and naphthyloxycarbonyl.

Examples of the alkylsulfonyl group include alkylsulfonyl groups having 2 to 18 carbons such as mesyl, ethylsulfonyl, and propylsulfonyl.

Examples of the arylsulfonyl group include arylsulfonyl groups having 2 to 18 carbons such as benzenesulfonyl and p-toluenesulfonyl.

The above-mentioned substituents added to the perylene ring may be further substituted by other of the above-mentioned substituents, or these substituents may be bonded to each other to form a ring such as, for example, a benzoperylene ring or a terrylene ring.

The positions at which the above-mentioned substituents are substituted are not particularly limited, but one of the substituents may preferably be added at the 3-position of the perylene ring. For example, when the structure is such that an amino group is bonded at the 3-position of the perylene ring, since the angles between the perylene ring and the amino group are held in relatively the same plane, the fluorescence is intense, and when used as an organic EL device, the luminance improves.

The number of carbons of the above-mentioned substituents is preferably 1 to 18, and more preferably 1 to 12. When the number of carbons in the substituents is large, since the solvent solubility is poor, there are concerns that purification might be difficult, the workability during fabrication of a device might be poor, and vapor deposition properties when fabricating a device by vapor deposition might be degraded.

The number of the above-mentioned substituents is not particularly limited, and it is preferably 1 to 8, and more preferably 1 to 4, from the viewpoint of ease of synthesis and the characteristics of the products and, in particular, when used for vapor deposition, from the viewpoint of the vapor deposition properties. When there are a plurality of substituents, they may be of the same type or a combination of different substituents.

Among the above-mentioned substituents, substituted or unsubstituted amino groups are preferred. Examples of the substituent on the amino groups include substituted or unsubstituted monovalent aliphatic hydrocarbon groups, substituted or unsubstituted monovalent aromatic hydrocarbon groups, substituted or unsubstituted monovalent aliphatic heterocyclic groups, and substituted or unsubstituted monovalent aromatic heterocyclic groups, and specific examples thereof include groups that are cited above as the substituents on the perylene ring. In particular, disubstituted amino groups are preferred, and diarylamino groups, where both of the substituents are aryl groups, are particularly preferred. The 'aryl groups' referred to here include aromatic hydrocarbon groups and aromatic heterocyclic groups, and the monovalent aromatic hydrocarbon groups and the monovalent aromatic heterocyclic groups that are cited above can preferably be used.

Specific examples of the disubstituted amino group include dimethylamino, diethylamino, dipropylamino, diisopropylamino, dibutylamino, di(*sec*-butyl)amino, di(*tert*-butyl)amino, dipentylamino, diisopentylamino, dineopentylamino, di(*tert*-pentyl)amino, dihexylamino, diisohexylamino, diheptylamino, dioctylamino, dinonylamino, didecylamino, diundecylamino, didodecylamino, ditridecyl, ditetradecylamino, dipentadecylamino, dihexadecylamino, diheptadecylamino, dioctadecylamino, dinonadecylamino, diphenylamino, dibiphenylylamino, bis(terphenylyl)amino, bis(quaterphenylyl)amino, di(*o*-tolyl)amino, di(*m*-tolyl)amino, di(*p*-tolyl)amino, dixylylamino, di(*o*-cumenyl)amino, di(*m*-tolyl)amino, di(*p*-cumenyl)amino, dimesitylamino, dipentalenylamino, diindenylamino, dinaphthylamino, bis(binaphthalenyl)amino, bis(ternaphthalenyl)amino, bis(quaternaphthalenyl)amino, diazulenylamino, diheptalenylamino, bis(biphenylenyl)amino, diindacenylamino, difluoranthenylamino, diacenaphthylenylamino, bis(aceanthrylenyl)amino, diphenalenylamino, difluorenylamino, dianthrylamino, bis(bianthracenyl)amino, bis(teranthracenyl)amino, bis(quateranthracenyl)amino, bis(anthraquinolyl)amino, diphenanthrylamino, ditriphenylenylamino, dipyrenylamino, dichrysenylamino, dinaphthacenylamino, dipleiadenylamino, dipicenylamino, diperylenylamino, bis(pentaphenyl)amino, dipentacenylamino, bis(tetraphenylenyl)amino, bis(hexaphenyl)amino, dihexacenylamino, dirubicenylamino, dicoronenylamino, bis(trinaphthylenyl)amino, bis(heptaphanyl)amino, diheptacenylamino, dipyranthrenylamino, diovalenylamino, methylethylamino, methylpropylamino, methylbutyl, methylpentylamino, methylhexylamino, ethylpropylamino, ethylbutylamino, ethylpentylamino, ethylhexylamino, propylbutylamino, propylpentylamino, propylhexylamino, butylpentylamino, butylhexylamino, pentylhexylamino, phenylbiphenylylamino, phenylterphenylylamino, phenylnaphthylamino, phenylanthrylamino, phenylphenanthrylamino, biphenylylnaphthylamino, biphenylylanthrylamino, biphenylylphenanthrylamino, biphenylylterphenylylamino, naphthylanthrylamino, naphthylphenanthrylamino, naphthylterphenylylamino, anthrylphenanthrylamino, anthrylterphenylylamino, methylphenylamino, methylbiphenylylamino, methylnaphthylamino, methylanthrylamino, methylphenanthrylamino, methylterphenylylamino, ethylphenylamino, ethylbiphenylylamino, ethylnaphthylamino, ethylanthrylamino, ethylphenanthrylamino, ethylterphenylylamino, propylphenylamino, propylbiphenylylamino, propylnaphthylamino, propylanthrylamino, propylphenanthrylamino, propylterphenylylamino, butylphenylamino, butylbiphenylylamino, butylnaphthylamino, butylanthrylamino, butylphenanthrylamino, butylterphenylylamino, pentylphenylamino, pentylbiphenylylamino, pentylnaphthylamino, pentylanthrylamino, pentylphenanthrylamino, pentylterphenylylamino, hexylphenylamino, hexylbiphenylylamino, hexylnaphthylamino, hexylanthrylamino, hexylphenanthrylamino, hexylterphenylylamino, heptylphenylamino, heptylbiphenylylamino, heptylnaphthylamino, heptylanthrylamino, heptylphenanthrylamino, heptylterphenylylamino, octylphenylamino, octylbiphenylylamino, octylnaphthylamino, octylanthrylamino, octylphenanthrylamino, octylterphenylylamino, dipyridylamino, diquinolylamino, diisoquinolylamino, dipyrimidinylamino, and phenylpyridylamino.

The number of amino groups with which the perylene ring is substituted is not particularly limited. In order to shift the fluorescence wavelength to longer wavelength, it is preferable to have a large number of substituents, but from the viewpoint of the formation of by-products during synthesis and the vapor deposition properties, the number of amino group substituents is preferably on the order of 1 to 4. In order to obtain a compound that exhibits orange to red fluorescence using a substituent with a comparatively simple amino group structure, it is preferable to introduce 2 to 4 substituents, but this makes control of the formation of isomers difficult. When there is one amino group, although it is easy to control the formation of isomers in which the amino group substitution position is different, since the fluorescence is yellowish green to yellow when the amino group itself has a comparatively simple structure, in order to obtain a compound that exhibits orange to red fluorescence, it is necessary to make the structure of the amino group somewhat complicated by further adding a substituent to the aryl group with which the amino group is substituted. However, when this Compound (A) is used as a host together with a doping material, a compound that exhibits a yellowish green to yellow fluorescence may be employed without any problem.

Representative examples of Compound (A) are given in Table 1, but Compound (A) is not limited thereby (in Table 1, *t*-Bu denotes a tertiary butyl group, Ph denotes a phenyl group, and Tol denotes a *p*-tolyl group).

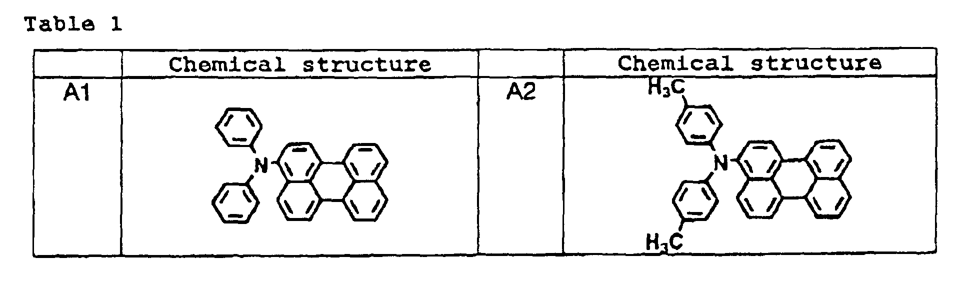

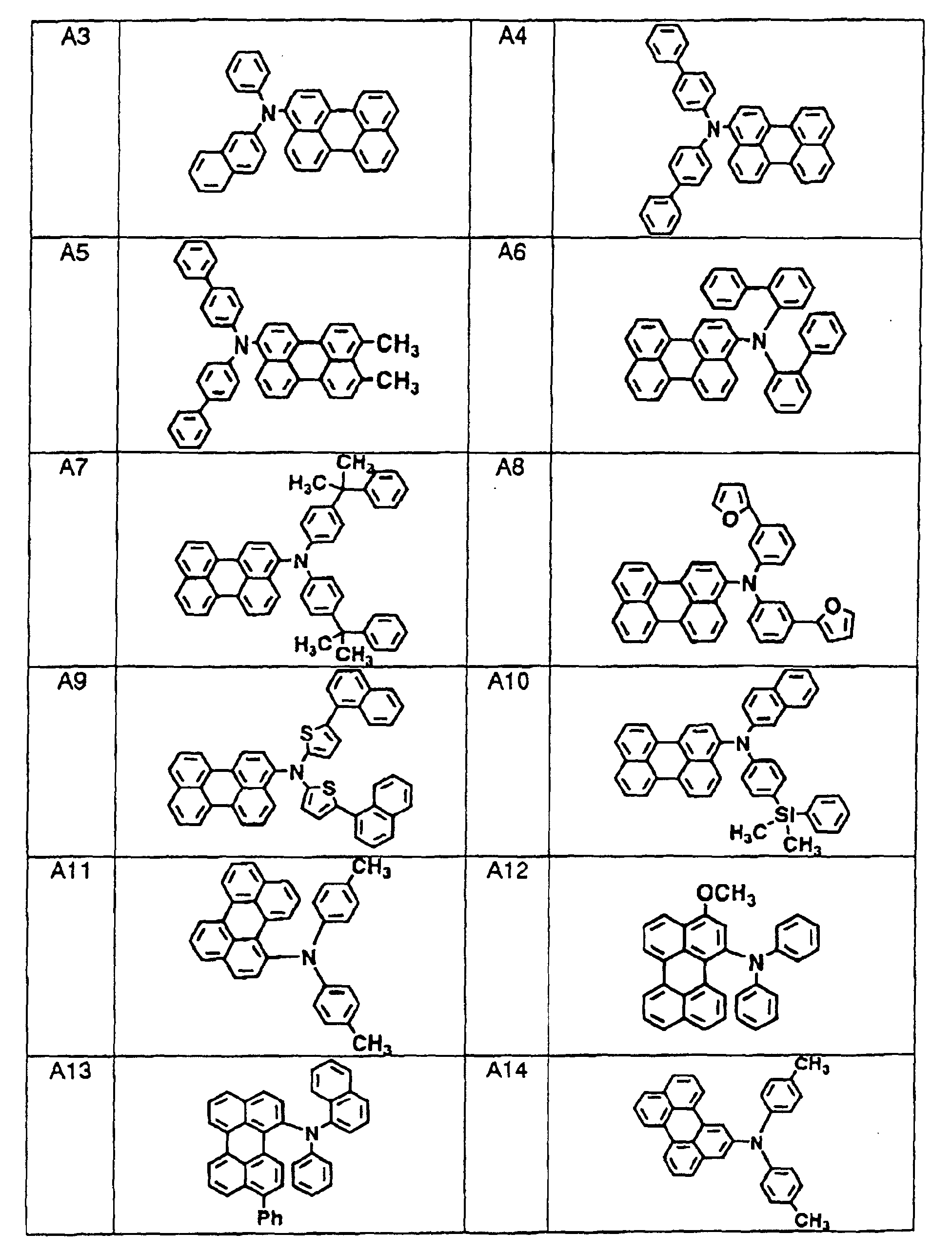

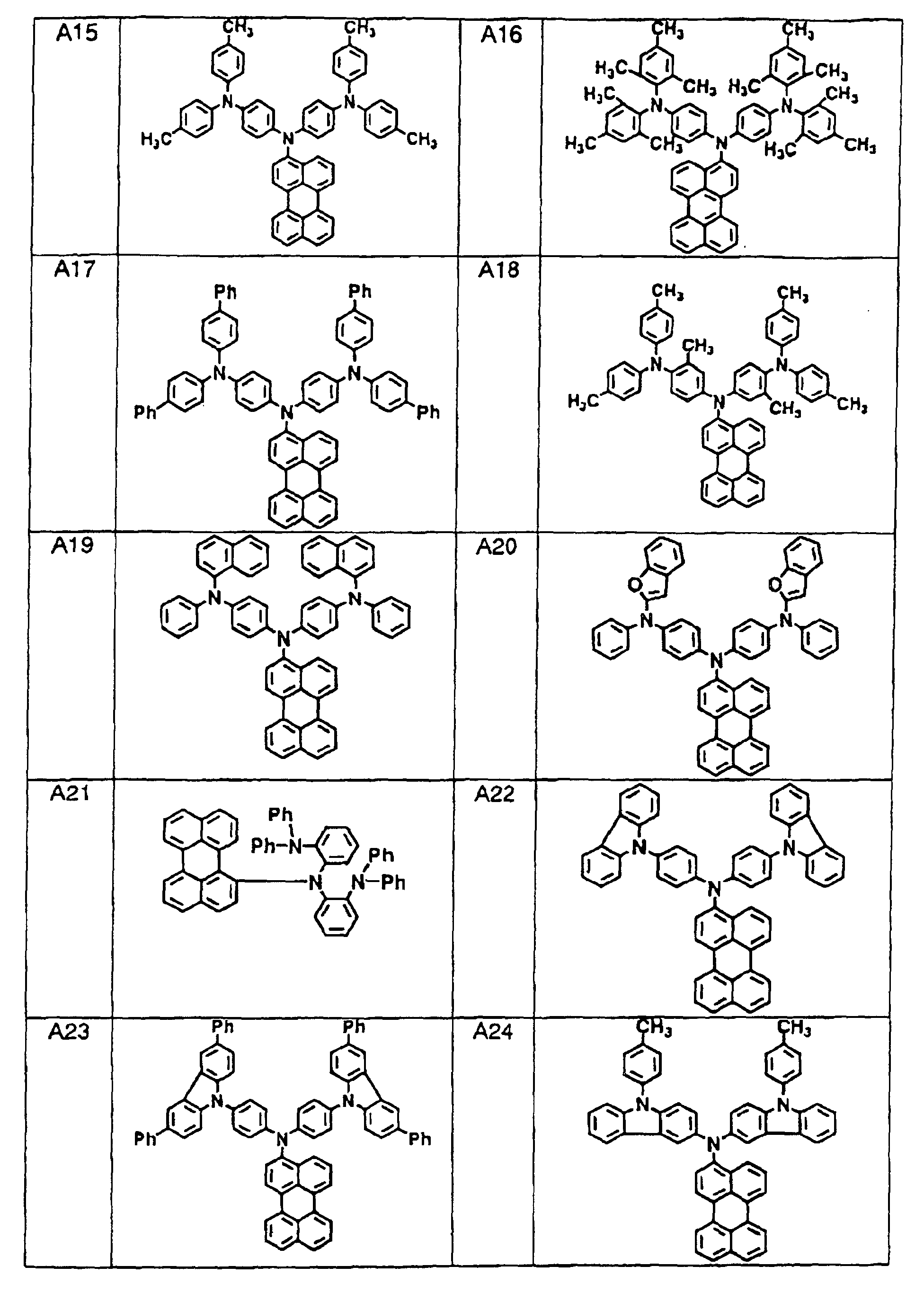

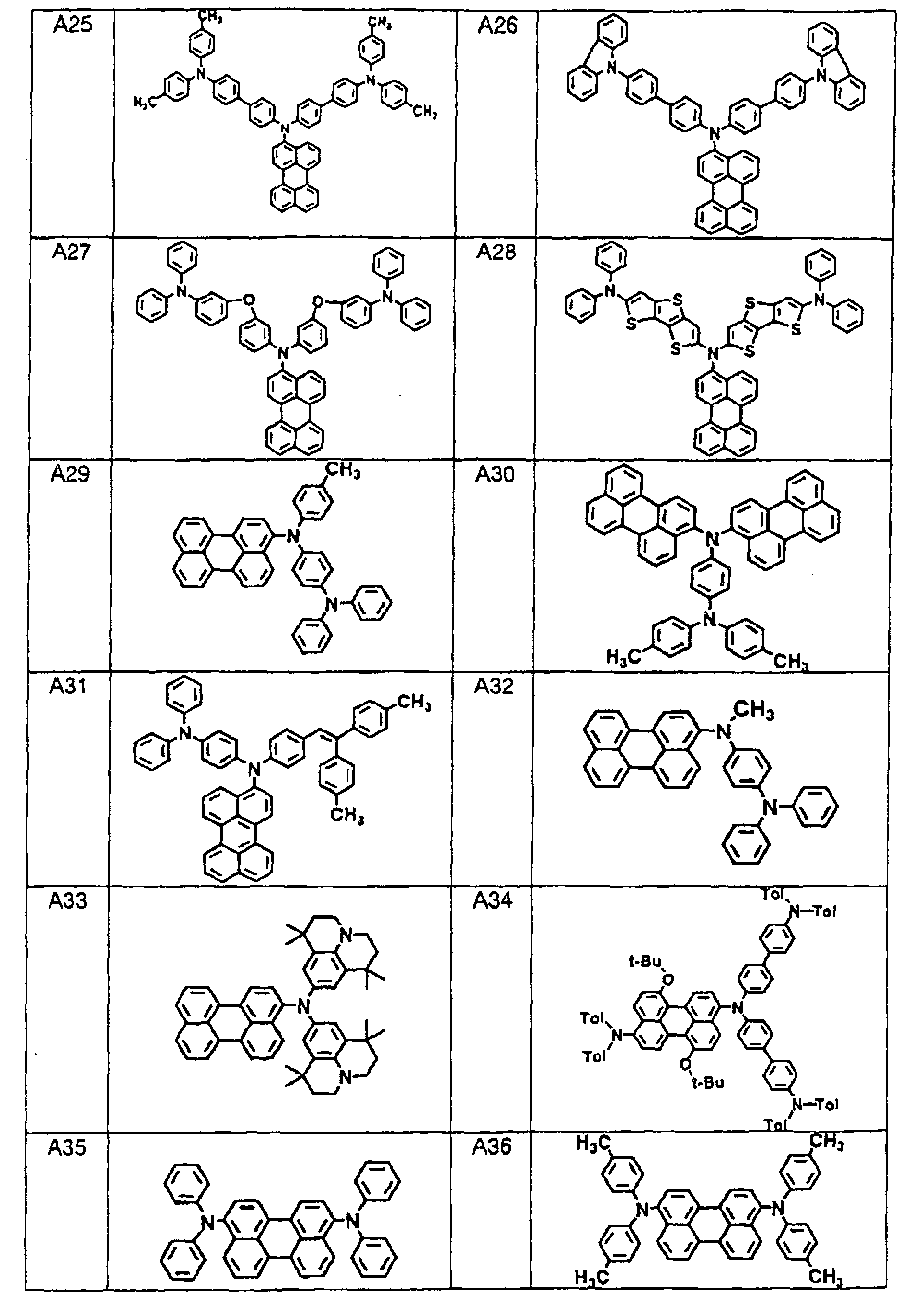

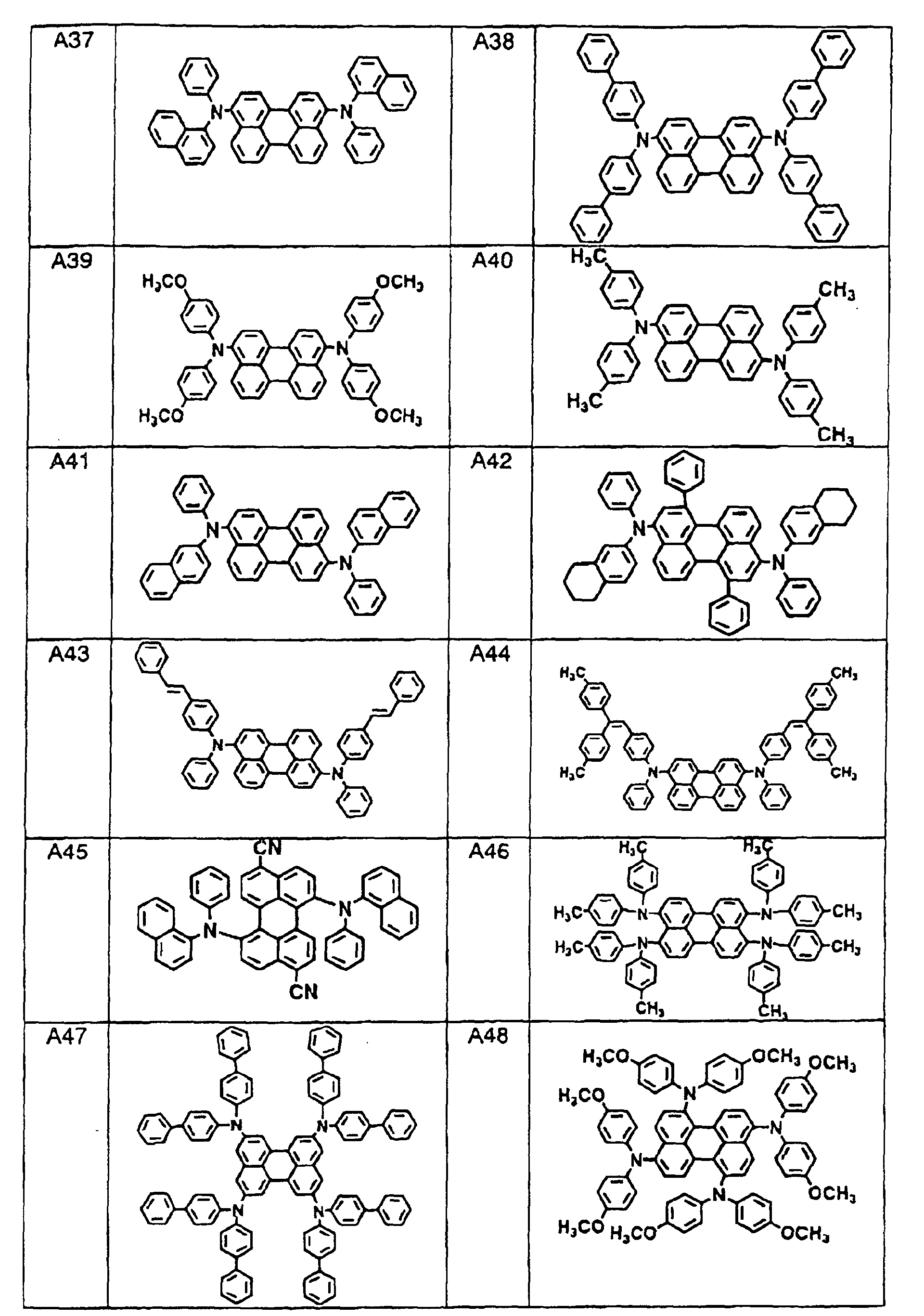

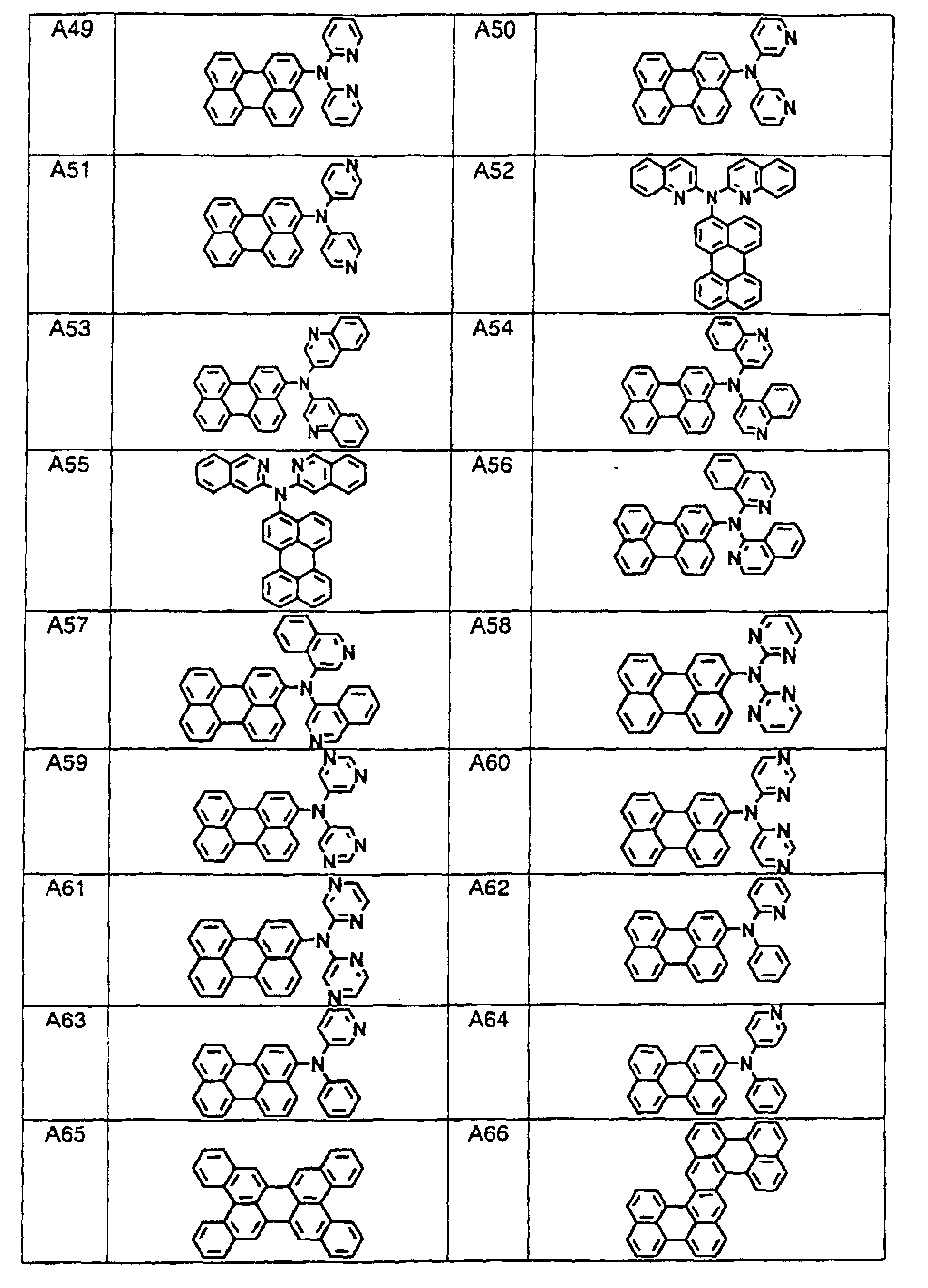

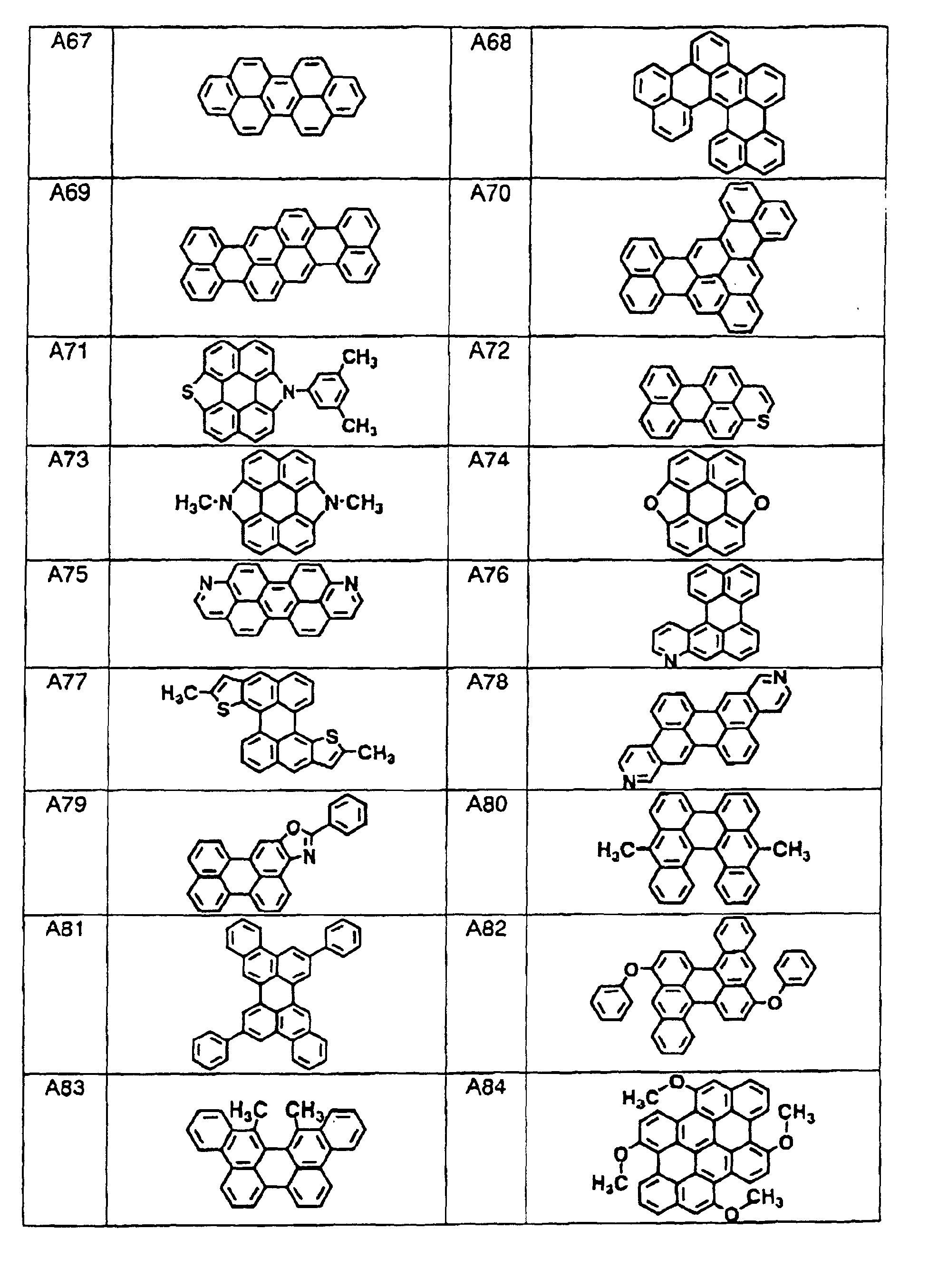

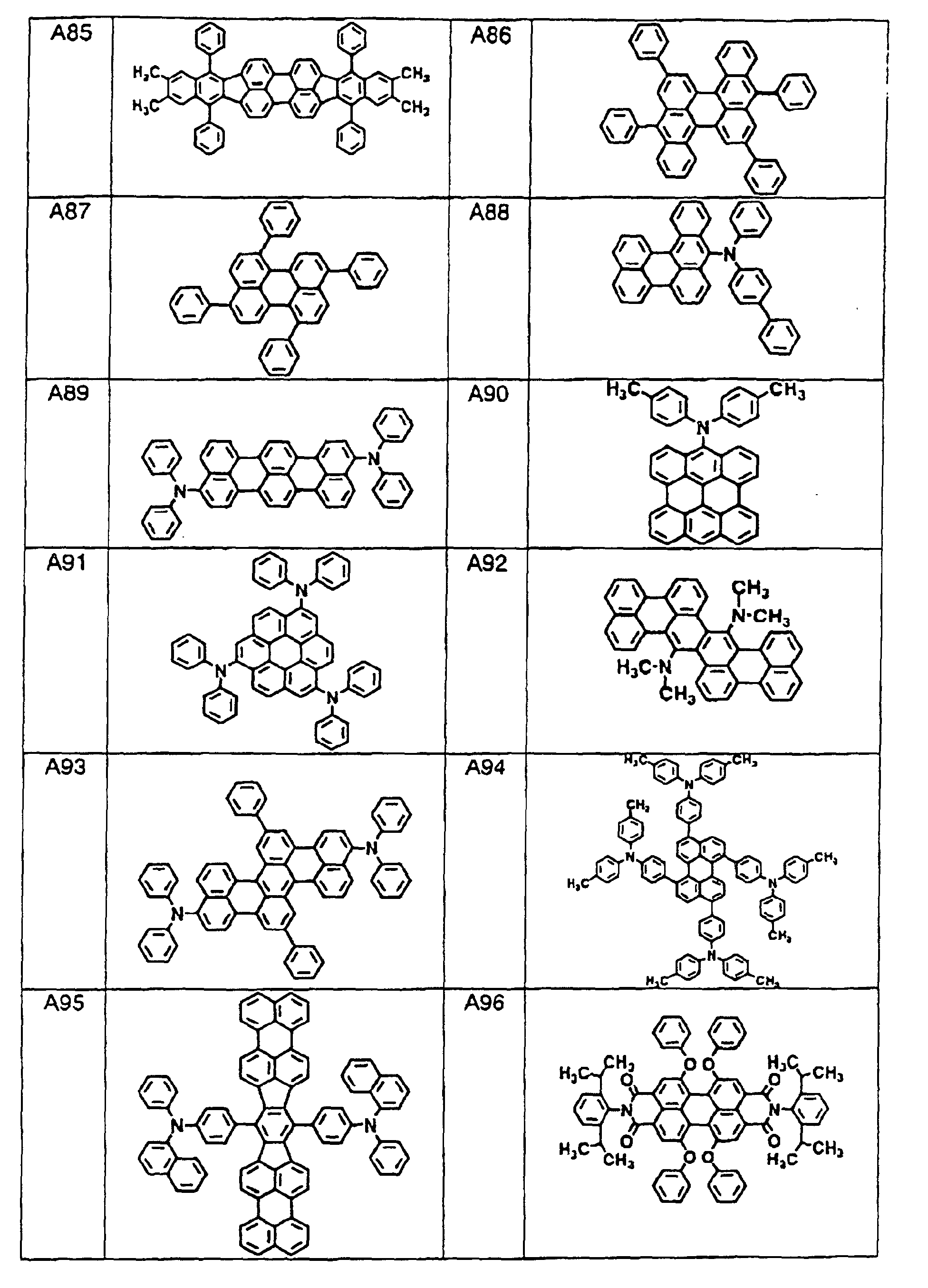

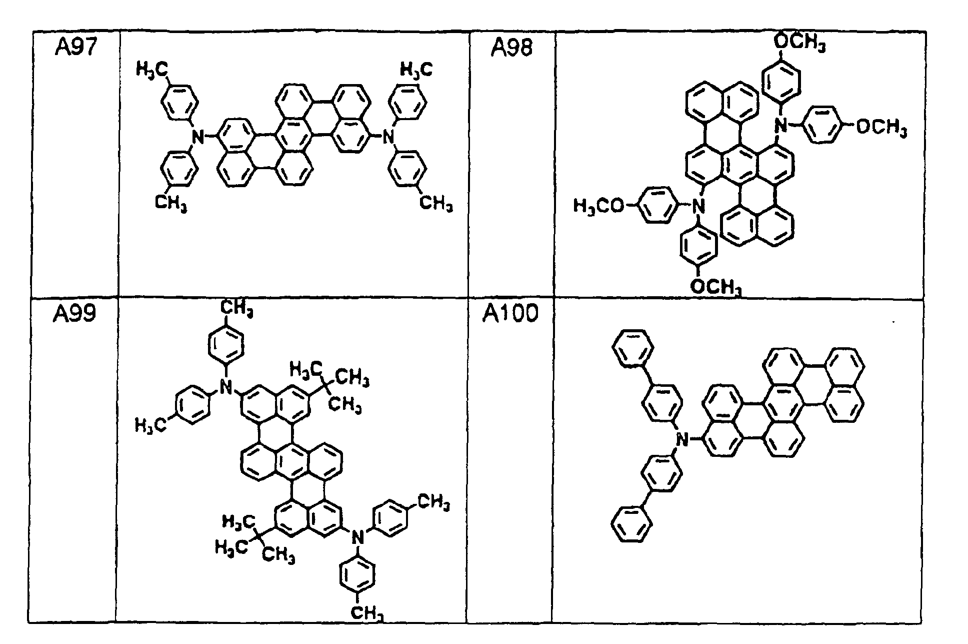

The above-mentioned Compound (A) may be used singly or two or more types thereof may be used in combination.

Compound (B) is a compound having a diketopyrrolopyrrole skeleton. Diketopyrrolopyrroles are a series of compounds represented by general formula [II] below. Some of these compounds are used as red pigments, and have high color purity and intense fluorescence characteristics.

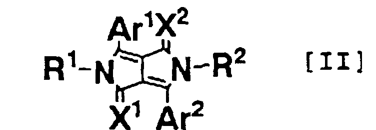

In general formula [II], R¹ and R² independently denote a group selected from a hydrogen atom, a substituted or unsubstituted alkyl group, and a substituted or unsubstituted aryl group, and Ar¹ and Ar² independently denote a group selected from a substituted or unsubstituted aryl group. The aryl group here may be an aromatic heterocyclic group having a heteroatom in the ring. With regard to the groups with which the groups above are substituted, those cited above as substituents on the perylene ring can be cited. X¹ and X² denote O, S, Se, NE¹, and CE²E³. Examples of E¹ to E³ include the groups cited above as substituents on the perylene ring, but in order to maintain the characteristics of the diketopyrrolopyrroles, it is necessary for the substituent to be electron-withdrawing, and it is preferable that E¹ is always an electron-withdrawing group and at least one of E² and E³ is an electron-withdrawing group. Examples of the electron-withdrawing groups include COOR, COR, and CN (R is a general substituent such as an alkyl group or an aryl group).

The diketopyrrolopyrrole skeleton may have various of the substituents cited above as substituents on the perylene ring as long as they do not greatly interfere with the performance as an organic EL material and, in particular, it is preferable to have an amino group as a substituent that can enhance the fluorescence characteristics and redden the fluorescence color. With regard to the substitution position, there are an alkyl group and/or an aryl group denoted by R¹ and R², and Ar¹ and/or Ar², etc., and it is preferable for a substituent to be on the Ar¹ or Ar² from the viewpoint of ease of synthesis and the product stability and properties. More preferably, a compound having each of Ar¹ and Ar² substituted with an amino group. as shown in general formula [I] below, is used. 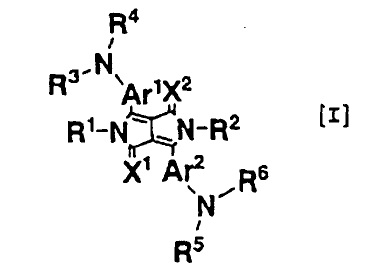 (In the formula, R¹ to R⁶ independently denote a hydrogen atom or a substituted or unsubstituted alkyl or aryl group (which may have a heteroatom in the ring). Ar¹ and Ar² independently denote a substituted or unsubstituted aryl group (which may have a heteroatom in the ring). X¹ and X² independently denote O, S, Se, NE¹, or CE²E³, E¹ denotes an electron-withdrawing group, and E² and E³ denote hydrogen atoms or substituents but at least one thereof denotes an electron-withdrawing group.)

The amino groups are preferably the aforementioned disubstituted amino groups, and particularly preferably the diarylamino groups.

Representative examples of Compound (B) are given in Table 2, but Compound (B) is not limited thereby (in Table 2, Me denotes a methyl group, Et denotes an ethyl group, Pr denotes a propyl group, iPr denotes an isopropyl group, n-Hex denotes a normal hexyl group, and *t*-Bu denotes a tertiary butyl group).

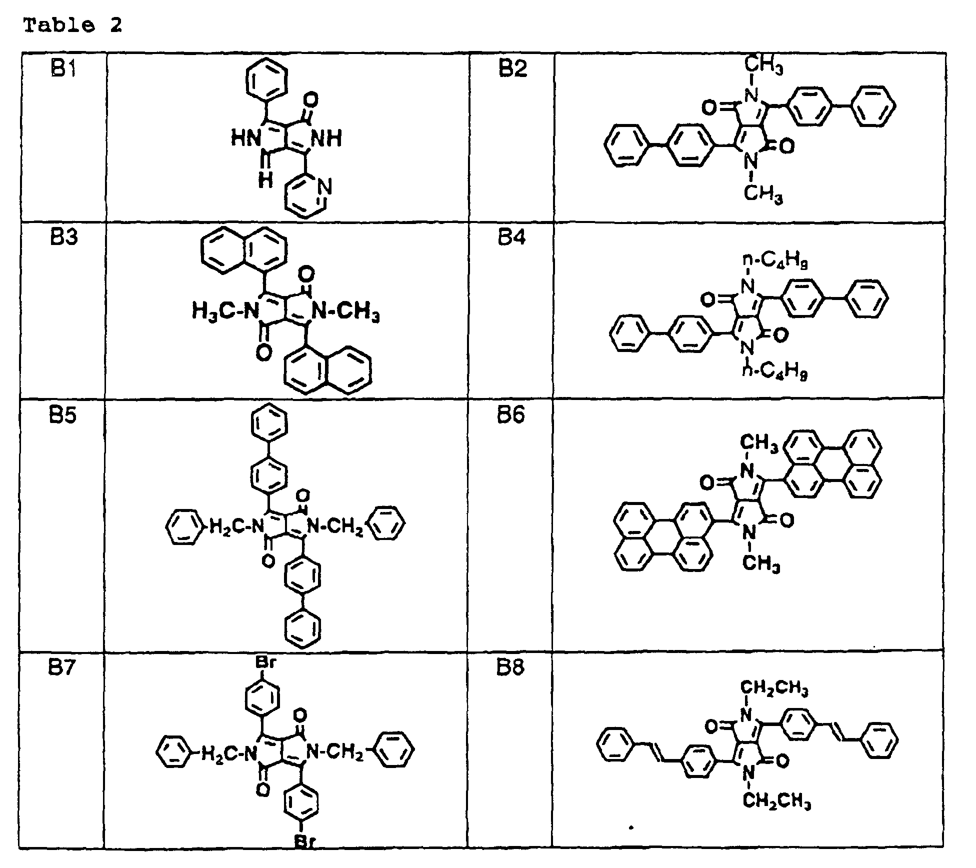

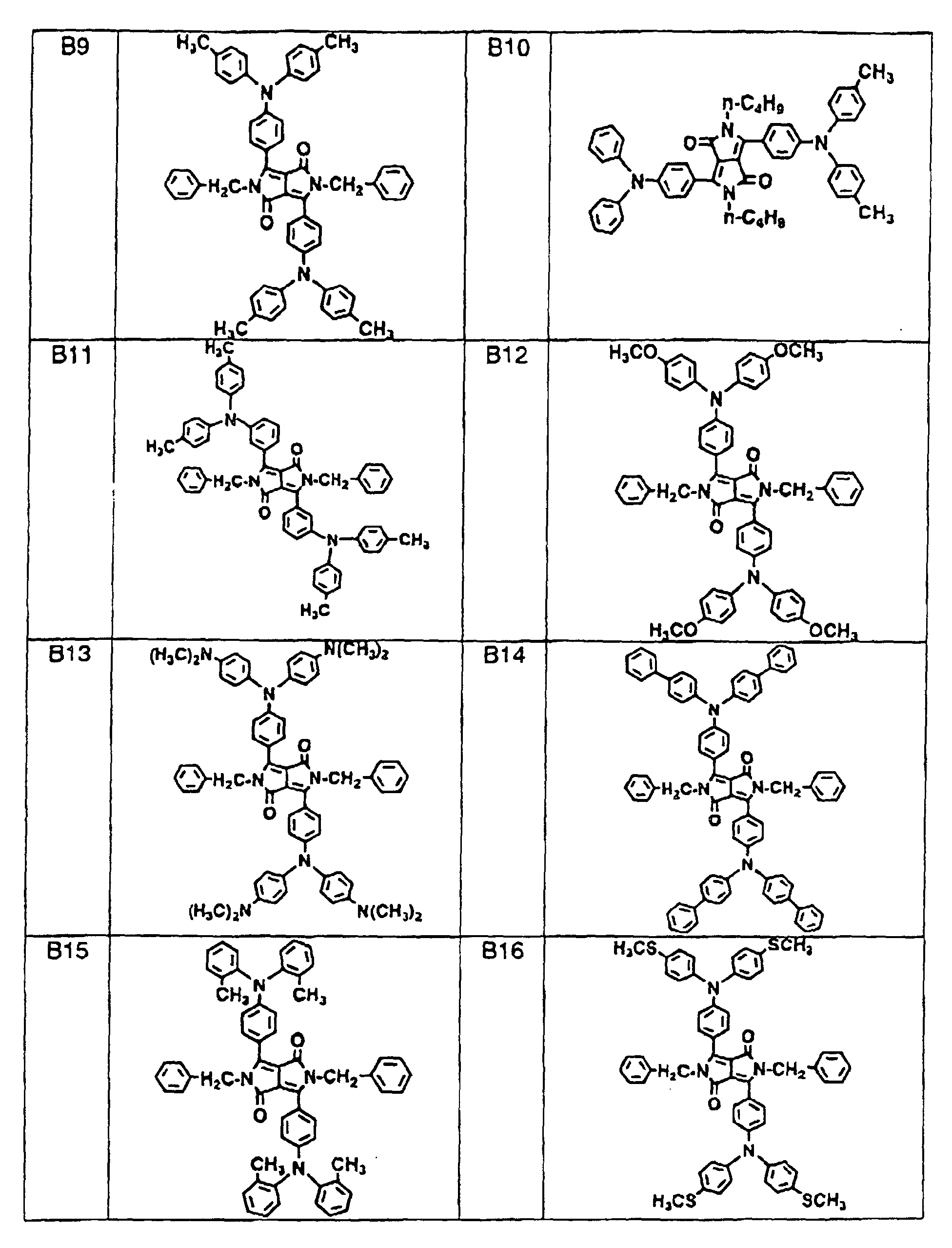

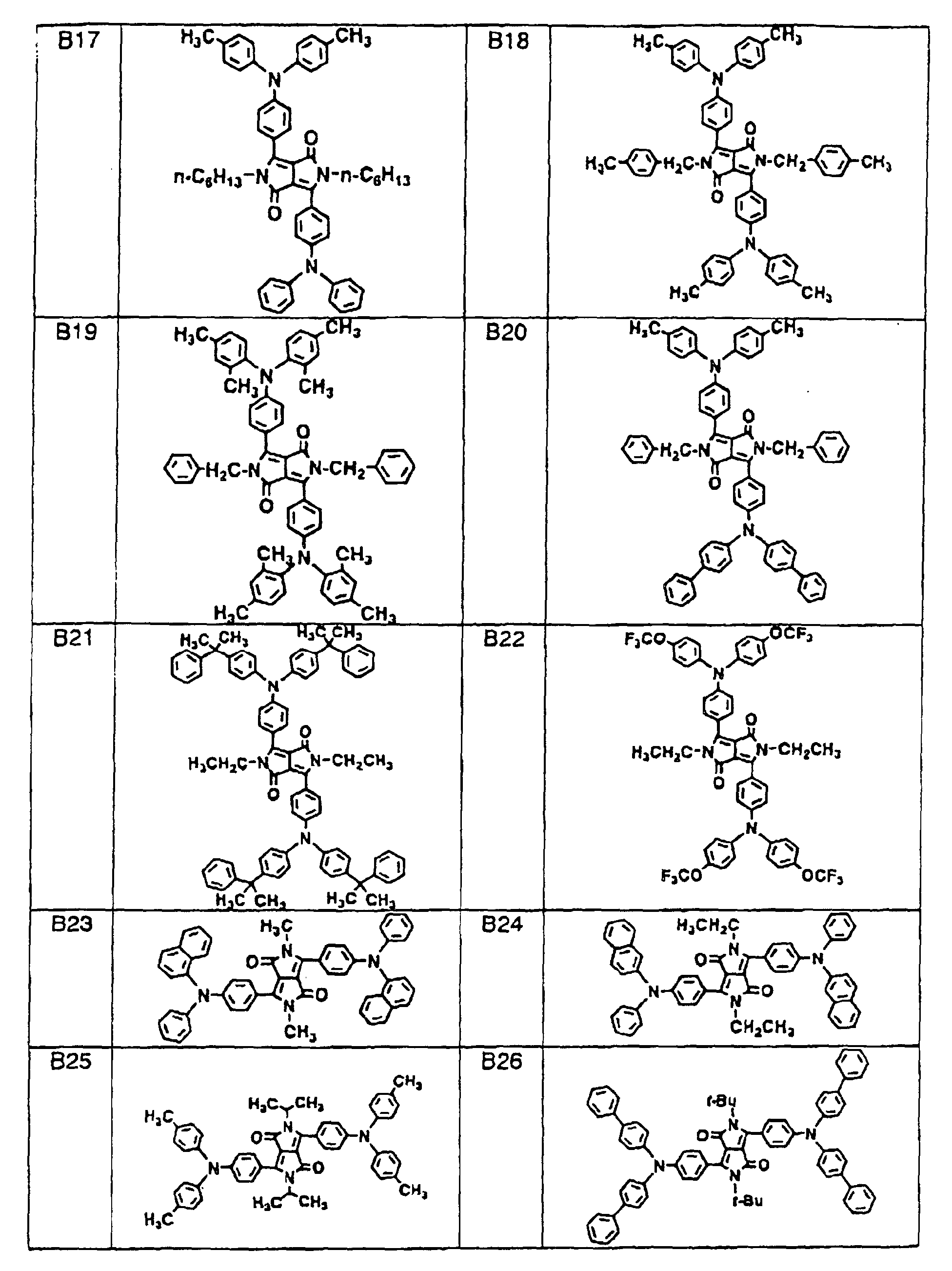

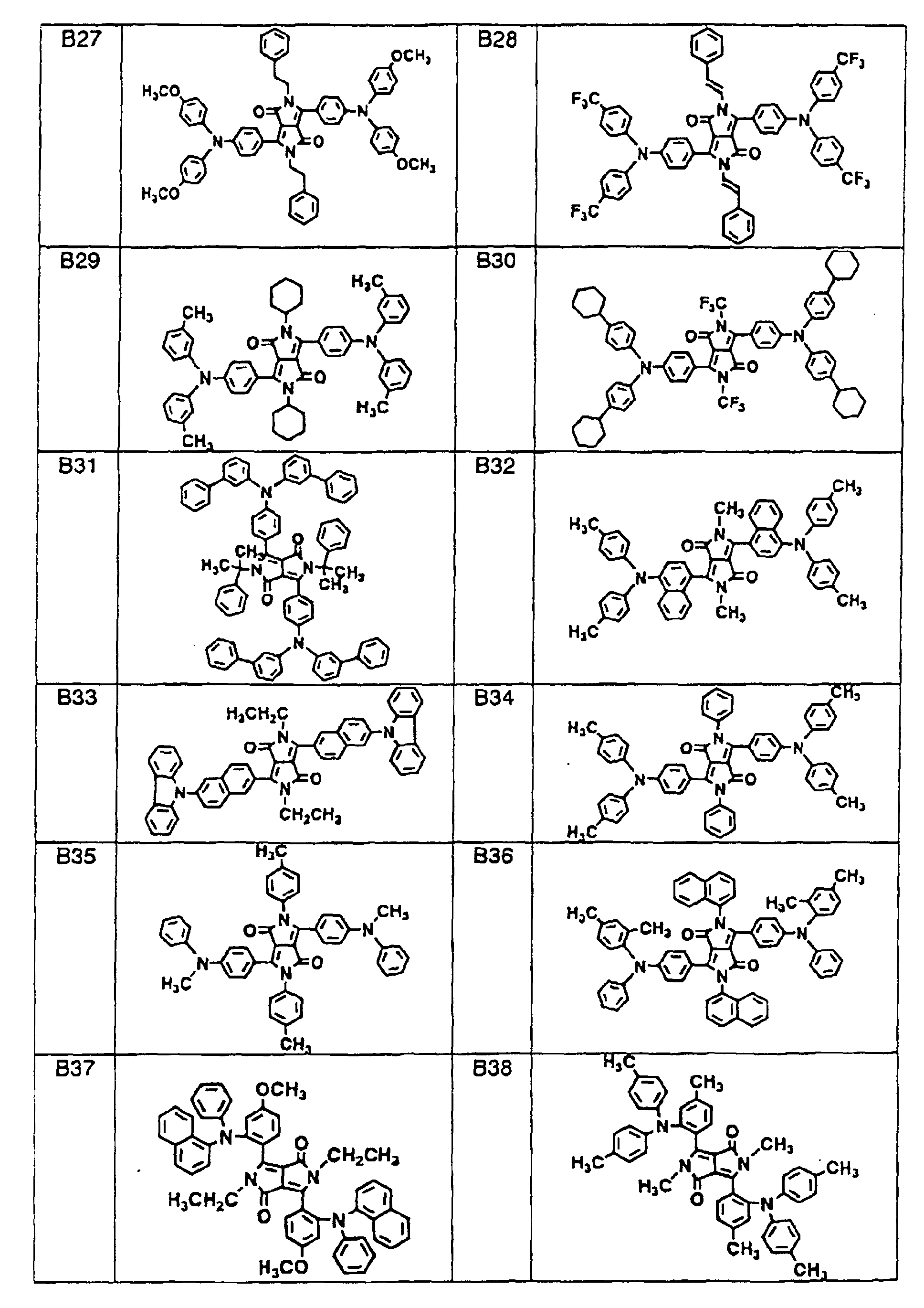

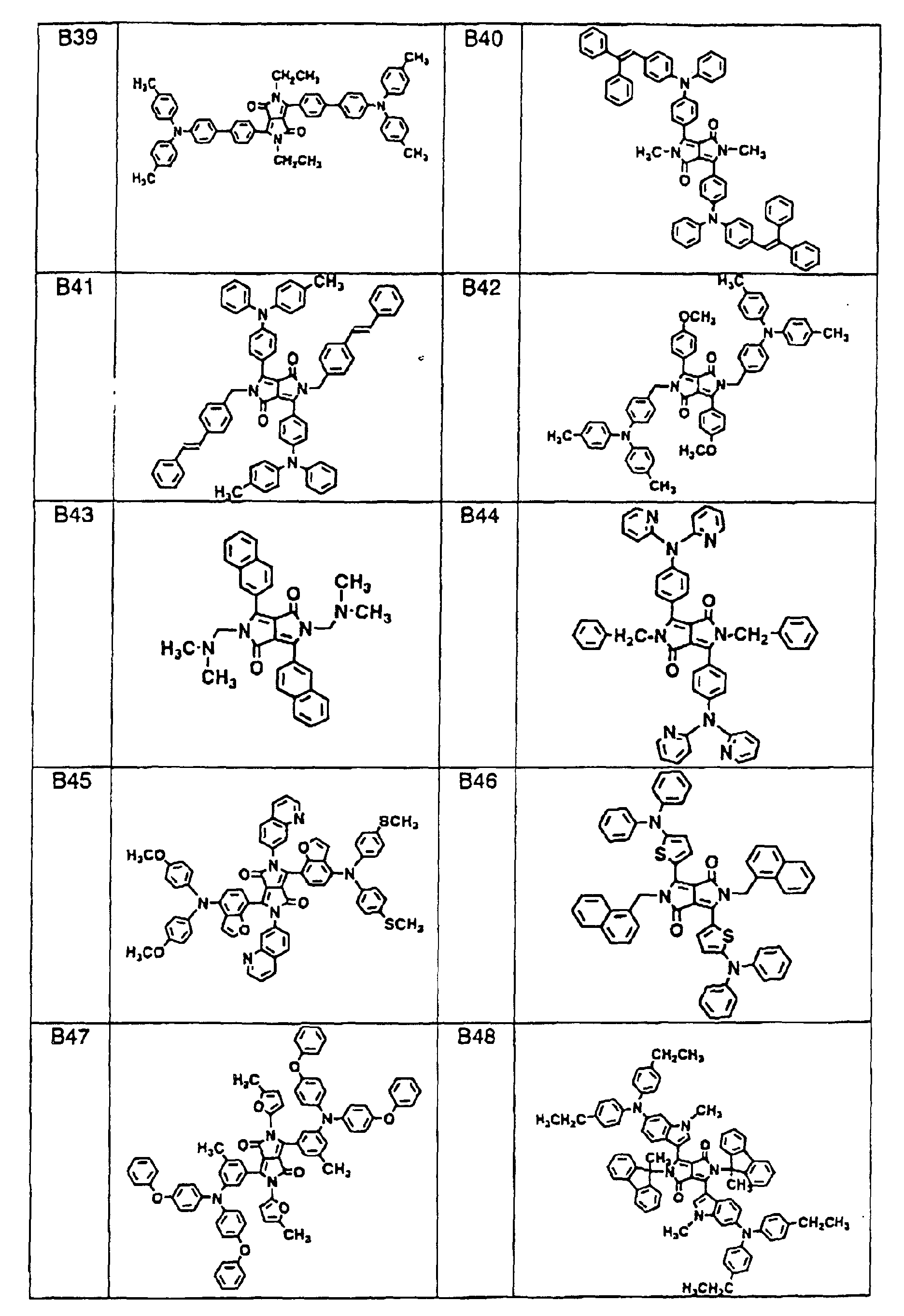

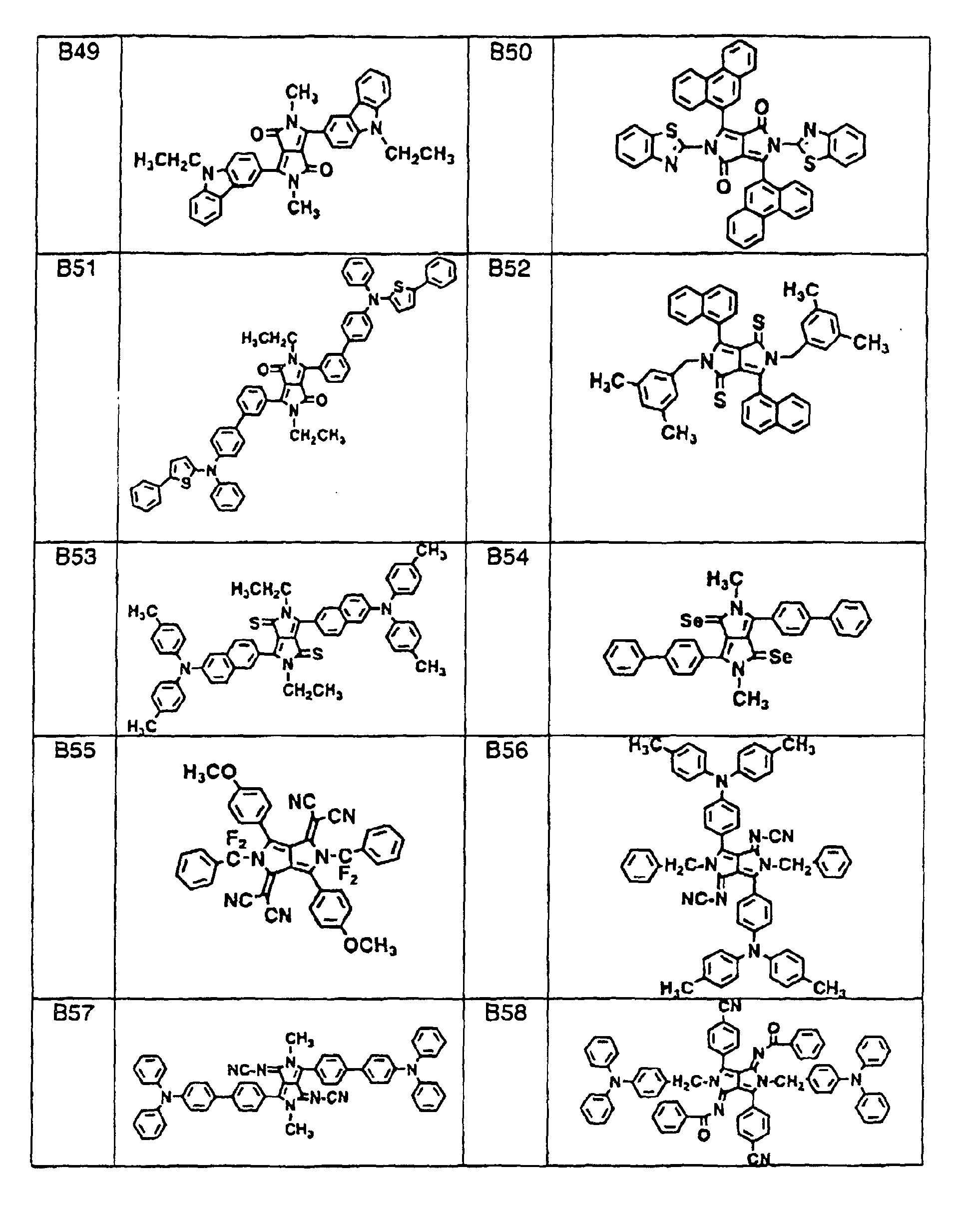

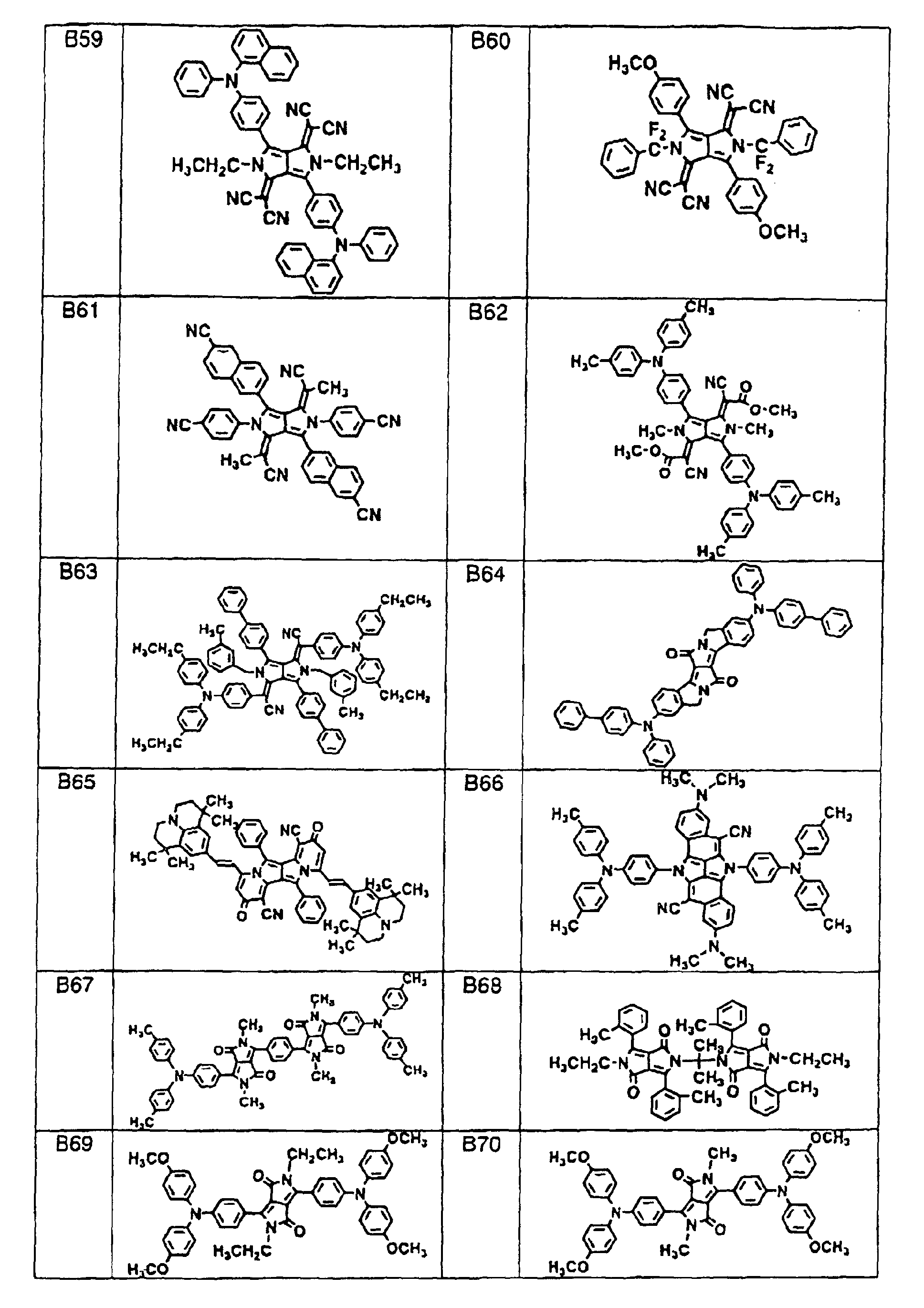

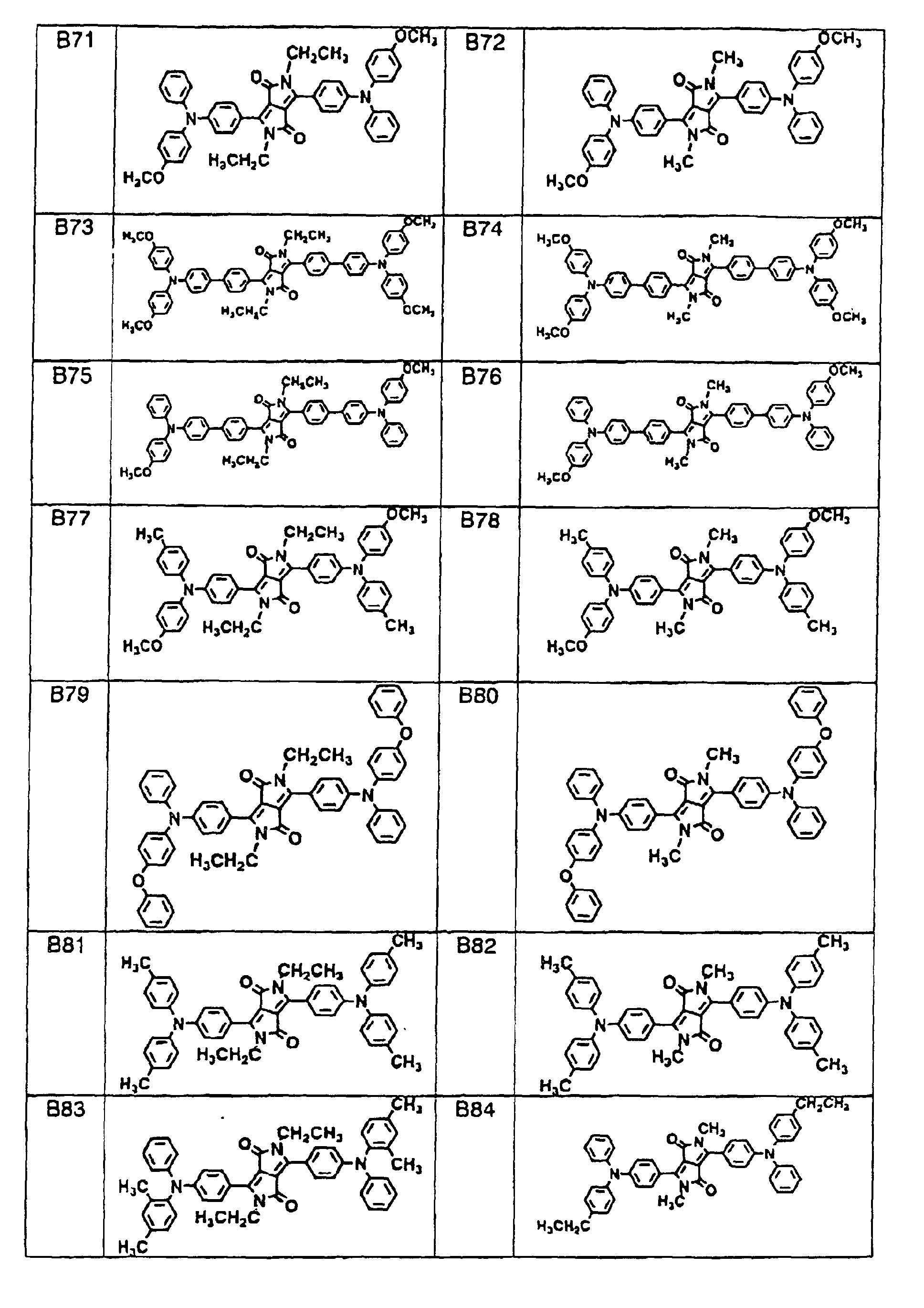

The above-mentioned Compound (B) may be used singly or two or more types thereof may be used in combination.

The present inventors have found that, although good characteristics can be obtained by using each of the above-mentioned Compound (A) and Compound (B) individually, or by the combined use of each thereof with another material, when the two are combined, energy is transferred particularly efficiently to Compound (B) from Compound (A), which has been excited by charge recombination, thus increasing the proportion of excited Compound (B) and, furthermore, since Compound (B) is uniformly distributed in Compound (A), the excited Compound (B) is less deactivated and emits light efficiently, thereby giving a very high effect as a material for a light-emitting layer from the viewpoint of high luminance, high efficiency, and long lifetime. Depending on the type of material, the roles of Compounds (A) and (B) are reversed, and in this case also, a very high effect of high luminance, high efficiency, and long lifetime can be obtained. In addition, since the combination of Compounds (A) and (B) easily satisfies the requirements for a host and a dopant for emitting yellow to red light as described below in an explanation of the organic EL device, when the combination is used as a light-emitting layer, it gives a yellow to red luminescence with high luminance and high efficiency.

The combination of Compounds (A) and (B) is useful in realizing, in particular, a red luminescent material having high color purity, high luminance, and high efficiency. Since Compound (A) has a perylene skeleton, strong luminescence can be expected from its fused aromatic rings, its glass transition temperature and melting point are high, and it has high resistance (thermal resistance) to Joule heat generated during light emission. The use of Compound (A) can therefore improve the luminescence efficiency and the luminance, and lengthen the lifetime of light emission, but the use of Compound (A) as a luminescent material on its own often gives a broad luminescence spectrum. It is therefore difficult to increase the color purity and, in particular, achieve high purity red luminescence, and improvement is desired. On the other hand, Compound (B) exhibits red luminescence with particularly high color purity, but when it is used on its own as a luminescent material, the emission intensity is weak, and there is a desire for improvement in the luminescence efficiency. It is therefore highly preferable to use Compounds (A) and (B) in combination in order to compensate for the drawbacks of each of the above-mentioned materials and utilize their advantages.

Composition X may contain, depending on its application (as a light-emitting layer, as an electron injection layer, as a hole injection layer, etc.), a known material other than Compounds (A) and (B), such as, for example, an electron transporting compound (electron injecting material), a hole transporting compound (hole injecting material), a luminescent material, or a doping material, which will be described below in the explanation of the organic EL device. When a film is formed by a method other than vapor deposition, in order to enhance the film formation performance, Composition X can contain various types of polymers, which will be described later, and can also contain various types of additives such as an antioxidant, a UV absorbing agent, or a plasticizer.

With regard to the proportions of Compounds (A) and (B) in Composition X, taking into consideration the above-mentioned characteristics of (A) and (B), (A) is preferably used as a host, that is, a main component, and (B) is preferably used as a dopant, that is, a secondary component. That is, relative to the entire Composition X, (A) is preferably 50 to 99.999 wt %, and (B) is preferably 0.001 to 50 wt %. The mixing ratio by weight of Compounds (A) and (B) is preferably (A) : (B) = 99999:1 to 1:1.

A Composition Y contains a Compound (C) having, as a solid film (M-1) thereof, a fluorescence spectrum peak wavelength of 550 nm or longer, and a Compound (D) having, as a solid film (M-2) in which Compound (D) is contained at 5 wt% in Compound (C), an area at a wavelength of 600 nm or less in the fluorescence spectrum region of 500 to 800 nm of 20% or less of the entire area. The solid film (M-1) is a film formed from Compound (C) alone, and the solid film (M-2) is a film formed by mixing Compound (C) and Compound (D) at a proportion of Compound (D) of 5 wt %. The fluorescence spectra of these solid films are fluorescence spectra when excitation light is applied to the respective thin films.

In the present description, there are three types of luminescence from a compound or a material composition, that is, (1) fluorescence from a solution, (2) fluorescence from a solid film, and (3) EL emission from a device, but they are the same phenomena and only differ in terms of the molecular state and the excitation mode. When there is no need to differentiate the state or the mode, they are therefore expressed simply as luminescence unless otherwise specified. It should be noted that luminescence from a device itself and from a film forming the device is all EL emission unless otherwise specified.

In Composition Y, it can be assumed that Compound (C) is the host and Compound (D) is the dopant. When the excitation mechanism of a dopant molecule is considered as energy transfer from a host molecule, taking into account the loss during energy transfer, instead of aluminium quinoline complex, which is generally employed, it is necessary to employ a material having luminescence at a longer wavelength as a host for a dopant having a red luminescence. Specifically, the luminescence spectrum of the host and the absorption spectrum of the dopant ideally overlap each other to a great extent. Taking into consideration the Stokes shift of the dopant (difference between the absorption peak wavelength and the luminescence peak wavelength), it is preferable to use a host having an approximately yellow to orange luminescence spectrum for a dopant having a red luminescence. With regard to a specific value for the wavelength, when the short wavelength side peak wavelength is 550 nm or longer, it can be suitably used as a host compound in a light-emitting layer of an organic EL device that has an orange to red luminescence. With regard to the longer wavelength side, when the area on the long wavelength side of the luminescence spectrum of the host is larger than the area of the absorption spectrum of the dopant, since an energy transfer corresponding to the surplus area cannot be expected. it is preferable that the luminescence peak wavelength of the host is shorter than the absorption peak wavelength of the dopant. On the other hand, as for the properties of the host itself, since there is almost no material that shows strong red luminescence as a single film, it is preferable to select the host from materials that give reasonably intense luminescence having a peak wavelength of 650 nm or shorter. If the combination of host and dopant is a mismatch, even if both thereof have high luminescence strength, since energy transfer from the host to the dopant does not proceed smoothly, a good result cannot be obtained, and since luminescence from the host remains in some cases, a target color cannot be obtained.

With regard to the luminescence spectrum of the dopant, it is generally said that the luminescence peak wavelength is important as a factor for determining the color, but the present inventors have noted that the breadth of the spectrum is actually quite an important factor. When the spectrum is broadened, even if the peak wavelength is the same, a different color is obtained. In particular, in the case of red luminescence, when the spectrum tails at short wavelengths, the color becomes quite yellow. When the spectrum spreads toward long wavelengths, since the long wavelength side enters the near-infrared region, even though there is energy output, the output in the visible region decreases, and the luminance and the luminescence efficiency deteriorate. The present inventors have thus found that, compared with a general evaluation in which the broadness of the spectrum is expressed as a half-band breadth and the suitability as a dopant compound is evaluated in combination with the peak wavelength, an evaluation in which the ratio of an area in a short wavelength region from blue to yellow relative to the area of the entire visible spectrum is used as an index is simpler and more reliable.

Specifically, it has been found that, when a compound that has an area at 600 nm or shorter in the luminescence spectrum of 20% or less of the area in a wavelength region of 500 to 800 nm, and preferably 5% or less, is used as a dopant, its combination with a host compound having an emission spectrum peak wavelength of 550 nm or longer gives orange to red luminescence with high luminance, high efficiency, and a long lifetime.

When examining the EL emission spectrum of a device, it has been found that, when the above-mentioned area is 20% or less, the value of x in the CIE 1931 chromaticity diagram (chromaticity coordinate) is substantially 0.6 or more, and when the area is 5% or loss, the value of x is 0.63 or more. That is, with regard to the combination of Compound (C) and Compound (D), in an organic EL device, it is only necessary that Compound (D) as a dopant is excited by energy transfer from Compound (C) (host compound) having in the EL emission spectrum a peak wavelength of 550 nm or longer, and the luminescence occurs such that the area at a wavelength of 600 nm or shorter relative to the entire peak area in the range of 500 to 800 nm in the EL emission spectrum is 20% or less, and preferably 5% or less. The CIE chromaticity coordinates here are expressed as a combination of x and y values, but since, when a color in the region from yellow to red is pure and not contaminated by blue to green components, x + y is substantially 1, in the present description only the value of x is given.

In this way, it has been found that, as host and dopant materials for forming a light-emitting layer of an organic EL device material that can give orange to red luminescence with high luminance and long lifetime, the characteristics required are that the peak wavelength in the fluorescence spectrum, which is the same phenomenon with only the method of excitation differing, is at least 550 nm, and the proportion of the area of 600 nm or shorter is 20% or less. It should be noted that the fluorescence spectrum and the EL emission spectrum do not always coincide with each other, and they can be rather very different from each other for a given compound depending on the measurement environment and conditions. The fluorescence spectrum of a solution can vary greatly depending on environmental conditions such as the type of solvent, and taking into consideration the difference in solubility of respective compounds in a solvent, it is not easy to evaluate the spectra under the same conditions for all compounds. Furthermore, in a film formed by using a single compound that is in the category of Compound (D), which is used as a dopant, 'concentration quenching', in which the excitation energy is deactivated due to molecules of the same type being in proximity to each other thus lowering the luminescence intensity, easily occurs, and the fluorescence spectrum of a film formed from a single dopant gives a considerably longer wavelength than that of a doping film used in a device. Although the dopant compound is usually contained in an EL device light-emitting layer at about 0.01 to 10 wt% relative to the host compound, the fluorescence spectrum changes slightly depending on the proportion of the dopant added, and the spectrum area profile also changes slightly accordingly.

In view of the above-mentioned circumstances, as a result of examination of fluorescence spectra obtained in environmental conditions as close as possible to those in which an organic EL device emits light, the present inventors have found that orange to red EL emission can be obtained with high luminance, high efficiency, and long lifetime by use of a dopant, that is. Compound (D), that can give in combination with a host, that is, Compound (C), having, as a solid film, a fluorescence spectrum peak wavelength of 550 nm or longer, an area at a wavelength of 600 nm or shorter of 20% or less of the entire peak area in the range from 500 to 800 nm of the fluorescence spectrum, as a solid film containing 5 wt% of the dopant in the host compound.

Such characteristics of Composition Y containing Compounds (C) and (D) are very useful when selecting and evaluating Compounds (C) and (D). The host compound used for selecting Compound (D) is freely chosen from Compounds (C), and for many of Compounds (D), their spectral shape rarely changes greatly when Compound (C) is changed. This supports the finding that, in a combination that satisfies the requirements, energy is transferred from Compound (C) to Compound (D), and only (D) luminesces. In primary screening for selecting Compound (D), Compound (C) is unchanged, and relative differences in characteristics and ordering among Compounds (D) are found, and in secondary screening more appropriate combinations of Compound (C) and Compound (D) are found, thereby easily obtaining Composition Y that can be used as a light-emitting layer of an organic EL device. At this stage, by examining the spectral intensity while changing the mixing ratio in the film, an optimum ratio of the two compounds can be estimated.

Film formation for obtaining solid films (M-1) and (M-2) can be carried out by a film formation method involving vapor deposition, spin coating, etc., which is employed when forming a device as described below, and since this process is used not only for examining the fluorescence spectrum, but also for estimating the film formation suitability, the same film formation method as for fabricating a device is preferably used here under conditions that are as similar as possible to those for fabricating the device.

In the fluorescence spectrum of a solid film, it is often difficult to eliminate the influence of scattered light reaching the detector of an instrument due to diffuse reflection of excitation light from the film surface, etc. depending on the properties of the film and the specification of the instrument. Therefore, the portion due to scattered light may be removed by data processing after measurement, or it might be necessary to avoid scattered light at 500 nm or longer and evaluate by using a spectrum from a longer wavelength portion than this, regardless of the range of 500 to 800 nm.

It is known that the luminescence color of an organic EL device is susceptible to a light interference effect since the film thicknesses of ITO and the organic layer used are of substantially the same order as the wavelength of the visible light region. Because of this, even when the same compound is used, the chromaticity is greatly changed in some cases by varying the ITO film thickness or changing the constitution and the film thickness of the organic layers including not only the light-emitting layer but also the hole injection layer and the electron injection layer, and even when measuring the fluorescence spectrum of a solid film having the same film thickness as that of the light-emitting layer of the device, the ordering among compounds in the fluorescence spectra and the ordering in the EL emission spectra can be reversed. It is also possible to employ this effect positively to obtain a chromaticity closer to a target value.

Although the relationship between the host and the dopant should be evaluated from the functional viewpoints of film formation and luminescence and does not simply show a quantitative ratio, from the viewpoint of the film forming properties of the host being adequately exhibited and the dopant being made to give luminescence without causing concentration quenching, the proportion of the host relative to the total of the host and the dopant is usually at least 50 wt %, and preferably at least 90 wt %, and from the viewpoint of the energy transfer from the host to the dopant being sufficiently carried out and the chromaticity and the intensity of the luminescence being sufficiently maintained, it is at most 99.999 wt %, and preferably at most 99.99 wt %. On the other hand, the proportion of the dopant is usually at most 50 wt %, preferably at most 10 wt %, and at least 0.001 wt %, preferably at least 0.01 wt %. That is, the mixing ratio of Compounds (C) and (D) is preferably 99999:1 to 1:1 as a ratio by weight, and more preferably 9999:1 to 9:1. Composition Y may contain a component other than Compounds (C) and (D), for example, various polymers that are added in order to improve the film formation performance and will be described below, a host material other than (C) and (D), a luminescent material (or doping material), a hole injecting material, an electron injecting material, or various additives such as an antioxidant, a UV absorbing agent, and a plasticizer. In this case, it is preferable for Compounds (C) and (D) to be contained in such amounts that, from the viewpoint of obtaining good device characteristics by maximizing the function of each of Compounds (C) and (D) and the function as a combination thereof, (C) is 10 to 99.999 wt % and (D) is 0.001 to 50 wt % relative to the entire light-emitting layer.

Specific examples of candidates for compounds that can be used as Compounds (C) and (D) include a large number of materials that give a yellow to red luminescence, for example, quinolinol complexes of metals such as aluminium and zinc, in particular, quinolinol complexes having a quinolinol ligand with a quinolinol ring enlarged by adding a substituent, for example, a quinolinol ligand with a comparatively large substituent such as styryl at, in particular, the 2-position; rubrene, dicyanomethylenepyran system compounds represented by DCM, DCJTB, etc., Nile red, squarylium dyes, porphyrin, phthalocyanine system compounds, perylenetetracarboxylic acid pigments, polymer materials such as oligothiophene derivatives, complexes of rare-earth metals such as europium, and complexes of metals such as iridium and platinum, that is, luminescent materials involving a triplet state.

Those particularly effective thereamong include the above-mentioned Compound (A) having a perylene ring and Compound (B) having a diketopyrrolopyrrole skeleton. These two compounds can be used as either Compound (C) or (D) depending on the type, number, etc. of substituents, but since a highly characteristic luminescence can be obtained, it is preferable to use Compound (A) having the perylene ring as Compound (C), that is as the host, and Compound (B) having the diketopyrrolopyrrole skeleton as Compound (D), that is as the dopant. This is because, although, with respect to Compound (A), a compound giving an intense yellow to orange luminescence particularly in a solid state can easily be obtained by adding a substituent having a comparatively simple structure, in order to obtain a compound that has a red luminescence, it is necessary to add a substituent having a rather complicated structure, and since many compounds have broad luminescence spectra tailing on the short wavelength side, it is rather difficult to satisfy the requirements for Compound (D) of the present invention. On the other hand, Compound (B) does not exhibit very intense fluorescence in the solid state, and it is colored with red to purple even in a reasonably thin film, but its solution shows very strong red fluorescence and, moreover, since it has a comparatively narrow luminescence spectrum, it is the most suitable material for satisfying the requirements for Compound (D).

The organic EL device, according to the present invention, fabricated by employing the above-mentioned Composition X and Composition Y, is now explained by reference to a drawing showing one example thereof.

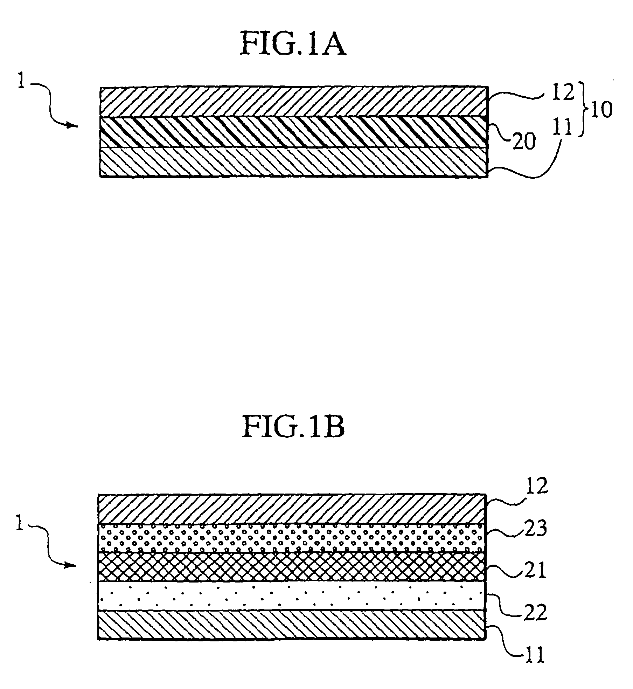

As shown in Fig. 1A, an organic EL device 1 comprises a pair of electrodes 10 formed from an anode 11 and a cathode 12, and at least one organic layer 20 formed between the electrodes 10. In the figure, the organic layer 20 comprising one layer is illustrated, but this organic layer 20 may be multi-layered, and may include a hole injection layer and/or an electron injection layer, which will be described below. The organic layer 20 includes at least one light-emitting layer. That is, when the organic EL device is of the one layer type in which the organic layer 20 is formed from only one layer, the organic layer is the light-emitting layer 20, and the structure is (anode/organic layer (light-emitting layer)/cathode).

In a preferred embodiment, as shown in Fig. 1B, an organic EL device 1 comprises a pair of electrodes 10 formed from an anode 11 and a cathode 12, and at least one light-emitting layer 21 formed between the electrodes 10, at least one hole injection layer 22 formed between the anode 11 and the light-emitting layer 21, and at least one electron injection layer 23 formed between the cathode 12 and the light-emitting layer 21. In the case of a multilayer type organic EL device having a multilayered organic layer as shown above, the structure is not limited to (anode/hole injection layer/light-emitting layer/electron injection layer/cathode) as illustrated, and may be a multilayered structure such as (anode/hole injection layer/light-emitting layer/cathode) or (anode/light-emitting layer/electron injection layer/cathode).

Each of the hole injection layer, the light-emitting layer, and the electron injection layer may be formed from two or more layers. When the hole injection layer is two or more layers, a layer adjacent to the anode can be called a hole injection layer, and a layer between the hole injection layer and the light-emitting layer can be called a hole transport layer. When the electron injection layer is two or more layers, a layer adjacent to the cathode can be called an electron injection layer, and a layer between the electron injection layer and the light-emitting layer can be called an electron transport layer.

In an organic EL device having an organic thin film two layer structure in which the layers are formed in the order of (anode/hole injection layer/light-emitting layer/cathode), since the light-emitting layer and the hole injection layer are formed individually, this structure enhances the hole injection efficiency from the hole injection layer to the light-emitting layer, thereby improving the luminance and the luminescence efficiency. In this case, it is preferable that the luminescent material used in the light-emitting layer has itself electron transporting properties, or that an electron transporting material is added to the light-emitting layer. On the other hand, in an organic EL device having an organic thin film two layer structure in which the layers are formed in the order of (anode/light-emitting layer/electron injection layer/cathode), since the light-emitting layer and the electron injection layer are formed individually, this structure enhances the electron injection efficiency from the electron injection layer to the light-emitting layer, thereby improving the luminance and the luminescence efficiency. In this case, it is preferable that the luminescent material used in the light-emitting layer has itself hole transporting properties, or a hole transporting material is added to the light-emitting layer. In the case of an organic thin film three layer structure, since there are a light-emitting layer, a hole injection layer, and an electron injection layer, the efficiency of recombination of holes and electrons in the light-emitting layer increases. In this way, making the organic EL device so as to have a multilayered structure enables the luminance and the lifetime to be prevented from deteriorating due to quenching. In a device having such a multilayered structure also, a luminescent material, a doping material, a hole transporting material and an electron transporting material for transporting carriers, etc. may be used as a mixture in the same layer, as necessary.

One embodiment of the organic EL device according to the present invention includes, as the above-mentioned single layer or multilayered organic layer, at least one layer formed from Composition X, which includes the aforementioned Compounds (A) and (B). Composition X can be used in any of the above-mentioned layers, and can particularly preferably be used as the light-emitting layer. Another embodiment thereof includes, as the light-emitting layer, at least one layer formed from Composition Y, which includes Compounds (C) and (D). Yet another embodiment thereof is preferably an organic EL device comprising both a layer formed from Composition (X) and a light-emitting layer formed from Composition (Y).

The light-emitting layer can, as necessary, contain any material, such as, for example, a luminescent material, a doping material, a hole transporting material (hole injecting material), an electron transporting material (electron injecting material), etc. In particular, in the case where a one layer type organic EL device is fabricated, the light-emitting layer preferably contains a hole injecting material and/or an electron injecting material for efficiently transporting holes injected from the anode and/or electrons injected from the cathode to the luminescent material.

Within one organic EL device, a plurality of light-emitting layers may be formed, for example, a light-emitting layer containing one pair of Compounds (A1) and (B1) or Compounds (C1) and (D1) and a light-emitting layer containing another pair of Compounds (A2) and (B2) or Compounds (C2) and (D2) may be formed or, alternatively, one light-emitting layer may contain a plurality of pairs, for example, the two pairs of Compounds (A1) and (B1) and Compounds (A2) and (B2). Furthermore, two or more types of each of Compounds (A), (B), (C), and (D) may be contained in the same light-emitting layer.

The hole injecting material referred to here means a compound that exhibits an excellent effect of injecting holes into the light-emitting layer or the luminescent material. prevents excitons generated in the light-emitting layer from moving to the electron injection layer or the electron injecting material, and has excellent thin film formation properties. Examples of such a hole injecting material include a phthalocyanine compound, a naphthalocyanine compound, a porphyrin compound, oxadiazole, triazole, imidazole, imidazolone, imidazolethione, pyrazoline, pyrazolone, tetrahydroimidazole, oxazole, oxadiazole, a hydrazone, an acylhydrazone, a polyarylalkane, stilbene, butadiene, a benzidine type triphenylamine, a styrylamine type triphenylamine. a diamine type triphenylamine, derivatives thereof, polyvinylcarbazole, polysilane, and a conductive polymer, but the examples are not limited thereto.

Among the above-mentioned hole injecting materials, particularly effective hole injecting materials include aromatic tertiary amine derivatives and phthalocyanine derivatives. Examples of the aromatic tertiary amine derivatives include triphenylamine, tritolylamine, tolyldiphenylamine, N,N'-diphenyl-N,N'-(3-methylphenyl)-1,1'-biphenyl-4,4'-diamine, N,N,N',N'-(4-methylphenyl)-1,1'-phenyl-4,4'-diamine, N,N,N',N'-(4-methylphenyl)-1,1'-biphenyl-4,4'-diamine, N,N'-diphenyl-N,N'-dinaphthyl-1,1'-biphenyl-4,4'-diamine, N,N'-(methylphenyl)-N,N'-(4-*n*-butylphenyl)-phenanthrene-9,10-diamine, and N,N-bis(4-di-4-tolylaminophenyl)-4-phenyl-cyclohexane, and oligomers and polymers having the above aromatic tertiary amine skeletons. Examples of the phthalocyanine (Pc) derivative include phthalocyanine derivatives and naphthalocyanine derivatives such as H₂Pc, CuPc, CoPc, NiPc, ZnPc, PdPc, FePc, MnPc, ClAlPc, ClGaPc, ClInPc, ClSnPc, Cl₂SiPc, (HO)AlPc, (HO)GaPc, VOPc, TiOPc, MoOPc, and GaPc-O-GaPc. The aforementioned hole injecting materials can be sensitized by adding an electron accepting material thereto.

The hole injecting materials above can be used singly or in a combination of two or more types. The hole injection layer 22 shown in Fig. 1B can preferably be formed by using these hole injecting materials.

On the other hand, the electron injecting material referred to here means a compound that exhibits an excellent effect of injecting electrons into the light-emitting layer or the luminescent material, prevents excitons generated in the light-emitting layer from moving to the hole injection layer or the hole injecting material, and has excellent thin film formation properties. Examples of such an electron injecting material include a quinoline metal complex, oxadiazole, a benzothiazole metal complex, a benzoxazole metal complex, a benzimidazole metal complex, fluorenone. anthraquinodimethane, diphenoquinone, thiopyran dioxide, oxadiazole, thiadiazole, tetrazole, perylenetetracarboxylic acid, fluorenylidenemethane, anthraquinodimethane, anthrone, and derivatives thereof. An inorganic/organic composite material in which bathophenanthroline is doped with a metal such as cesium (e.g., The Proceedings of the Society of Polymer Science, Japan, Vol. 50, No. 4, p. 660, 2001) can also be cited as an example of the electron injecting material, but the examples are not limited thereto.

Among the above-mentioned electron injecting materials, examples of particularly effective electron injecting materials include metal complex compounds and nitrogen-containing five-membered ring derivatives. Among the metal complex compounds, the 2-methylquinolinol complexes of gallium described in Japanese Unexamined Patent Application Publication No. 10-88121 can preferably be used. Specific examples of these compounds include bis(2-methyl-8-hydroxyquinolinate)(1-naphthalate) gallium complex, bis(2-methyl-8-hydroxyquinolinate)(2-naphthalate) gallium complex, bis(2-methyl-8-hydroxyquinolinate)(phenolate) gallium complex, bis(2-methyl-8-hydroxyquinolinate)(4-cyano-1-naphthalate) gallium complex, bis(2,4-dimethyl-8-hydroxyquinolinate)(1-naphthalate) gallium complex, bis(2,5-dimethyl-8-hydroxyquinolinate)(2-naphthalate) gallium complex, bis(2-methyl-5-phenyl-8-hydroxyquinolinate)(phenolate) gallium complex, bis(2-methyl-5-cyano-8-hydroxyquinolinate)(4-cyano-1-naphthalate) gallium complex, bis(2-methyl-8-hydroxyquinolinate) chlorogallium complex, and bis(2-methyl-8-hydroxyquinolinate)(*o*-cresolate) gallium complex, but the examples are not limited thereto. These compounds can be synthesized by a method described in the above patent publication.

Examples of other preferred metal complex compounds include lithium 8-hydroxyquinolinate, zinc bis(8-hydroxyquinolinate), copper bis(8-hydroxyquinolinate), manganese bis(8-hydroxyquinolinate), aluminium tris(8-hydroxyquinolinate), aluminium tris(2-methyl-8-hydroxyquinolinate), gallium tris(8-hydroxyquinolinate), beryllium bis(10-hydroxybenzo[h]quinolinate), and zinc bis(10-hydroxybenzo[h]quinolinate).

Preferred examples of the nitrogen-containing five-membered ring derivatives include oxazole, thiazole, oxadiazole, thiadiazole, and triazole derivatives, and specific examples thereof include 2,5-bis(1-phenyl)-1,3,4-oxazole, dimethyl POPOP, 2,5-bis(1-phenyl)-1,3,4-thiazole, 2,5-bis(1-phenyl)-1,3,4-oxadiazole, 2-(4'-tert-butylphanyl)-5-(4''-biphenyl)1,3,4-oxadiazole, 2,5-bis(1-naphthyl)-1,3,4-oxadiazole, 1,4-bis[2-(5-phenyloxadiazolyl)]benzene, 1,4-bis[2-(5-phenyloxadiazolyl)-4-*tert*-butylbenzene], 2-(4'-*tert*-butylphenyl)-5-(4''-biphenyl)-1,3,4-thiadiazole, 2,5-bis(1-naphthyl)-1,3,4-thiadiazole, 1,4-bis[2-(5-phenylthiadiazolyl)]benzene, 2-(4'-*tert*-butylphenyl)-5-(4''-biphenyl)-1,3,4-triazole, 2,5-bis(1-naphthyl)-1,3,4-triazole, and 1,4-bis[2-(5-phenyltriazolyl)]benzene. The aforementioned electron injecting materials can be sensitized by adding an electron-donating material.

The aforementioned electron injecting materials can be used singly or in a combination of two or more types. The electron injection layer 23 shown in Fig. 1B can preferably be formed by using these electron injecting materials.

The light-emitting layer 21 may further contain any host material other than the Compounds (A) to (D) above. In this case, Compound (A) and (B) may independently function as a dopant or function as a host material. Examples of such a host material include electron transporting materials such as a quinoline metal complex, a benzoquinoline metal complex, a benzoxazole metal complex, a benzothiazole metal complex, a benzimidazole metal complex, a benzotriazole metal complex, an imidazole derivative, an oxadiazole derivative, a thiadiazole derivative, and a triazole derivative; hole transporting materials such as a stilbene derivative, a butadiene derivative, a benzidine type triphenylamine derivative, a styrylamine type triphenylamine derivative, a diaminoanthracene type triphenylamine derivative, and a diaminophenanthrene type triphenylamine derivative; and polymer materials such as conductive polymers like polyvinylcarbazole, polysilane, etc. These host materials may be used singly or in a combination of two or more types.

The light-emitting layer 21 may further contain any dopant or luminescent material other than the Compounds (A) to (D) above. In this case, Compounds (A) and (B) may independently function as a dopant or function as a host material. Examples of such a luminescent material or dopant include anthracene, naphthalene, phenanthrene, pyrene, tetracene, coronene, chrysene, fluorescein, perylene, phthaloperylene, naphthaloperylene, perynone, phthaloperynone, naphthaloperynone, diphenylbutadiene, tetraphenylbutadiene, coumarin. oxadiazole, aldazine, bisbenzoxazoline, bisstyryl, pyrazine, cyclopentadiene, a quinoline metal complex, an aminoquinoline metal complex, an imine, diphenylethylene, vinylanthracene, diaminocarbazole, pyran, thiopyran, polymethine, merocyanine, an imidazole chelated oxinoid compound, quinacridone, rubrene, and derivatives thereof.

With regard to conductive materials that can be used as the anode 11 of the organic EL device shown in Fig. 1, those having a work function of larger than 4 eV are suitable, and examples thereof include carbon, aluminium, vanadium, iron, cobalt, nickel, tungsten, silver, gold, platinum, palladium, etc., alloys thereof, metal oxides such as tin oxide and indium oxide. which are called ITO substrate or NESA substrate, and organic conductive polymers such as polythiophene and polypyrrole.

With regard to conductive materials that can be used in the cathode 12, those having a work function of less than 4 eV are suitable, and examples thereof include magnesium, calcium, tin, lead, titanium, yttrium, lithium, lithium fluoride, ruthenium, manganese, etc. and alloys thereof. Representative examples of the alloys include magnesium/silver, magnesium/indium, and lithium/aluminium, but the examples are not limited thereto. Since the ratio of the alloy can be controlled by the heating temperature, the atmosphere, and the degree of vacuum during preparation, an alloy having an appropriate ratio can be prepared.

The anode and cathode may if necessary have a layered structure of two or more layers, and the thickness thereof is not particularly limited but is preferably on the order of 0.01 nm to 10 µm from the viewpoint of conductivity, transparency, film forming properties, etc. In the case of a material having high conductivity, the thickness allowance is large and it is therefore often determined with respect to other factors such as ease of film formation, maintenance of transparency, and the definition when fabricating a device. When it is used as a transparent electrode, the thickness is preferably 500 nm or less even for a highly transparent material such as ITO in order to ensure sufficient transparency, and in the case where a metal is used, it is preferably 50 nm or less. Since fluorides and oxides of alkali metals and alkaline earth metals such as lithium fluoride, magnesium fluoride, or lithium oxide added in order to enhance the electron injection properties have high insulating properties, even when the film thickness is 2 to 3 nm, the conductivity is substantially lost. In the case where such a material is used, a film is generally formed directly on top of the organic layer (electron injection layer) at a film thickness of 1 nm or less, and a film of a material that, among the above-mentioned materials, has comparatively high conductivity, such as aluminium or silver, is formed on the top of the above film.

In order to make the organic EL device according to the present invention give luminescence efficiently, the materials forming the device are sufficiently transparent in the luminescence wavelength region of the device, and at the same time in the case where light is emitted from the substrate side, it is essential for the substrate to be transparent. A transparent electrode can be produced by a method such as a vapor-deposition method or a sputtering method using the above-mentioned conductive material. In particular, the electrode on the light-emitting surface preferably has a light transmittance of at least 10%. The substrate is not particularly limited as long as it has mechanical and thermal strength and is transparent, and, for example, a glass substrate and a transparent polymer such as polyethylene, polyethersulfone. or polypropylene can preferably be used.

With regard to the method for forming each of the organic layers of the organic EL device, it is possible to employ either a dry system film formation method such as vacuum vapor deposition, sputtering, plasma, or ion plating, or a wet system film formation method such as spin coating, dipping, or flow coating. The film thickness of each layer is not particularly limited, but if the film thickness is too thick, then a large applied voltage is required to obtain a fixed light output, thus degrading the efficiency, whereas in contrast if the film thickness is too thin, then pin-holes, etc, are generated, and sufficient luminance is hard to achieve even by applying an electric field. It is therefore necessary to set an appropriate film thickness. The film thickness (after drying) of the organic layer is therefore preferably in the range of 1 nm to 1 µm, and more preferably in the range of 10 nm to 0.2 µm. The thickness of each of the hole injection layer 22, the electron injection layer 23, and the light-emitting layer 21 is not particularly limited, but is preferably on the order of 1 nm to 0.5 µm.

When the organic layer is formed by a wet system film formation method, the materials forming the organic layer are dissolved or dispersed in an appropriate solvent such as toluene, chloroform, tetrahydrofuran, or dioxane and then formed into a film. The solvent used here can be either a single solvent or a mixed solvent. In order to improve the film forming properties, prevent pin-holes in the film, etc., an appropriate polymer or an additive can be used, Examples of such a polymer include insulating polymers such as polystyrene, polycarbonate, polyarylate, polyester, polyamide, polyurethane, polysulfone, polymethyl methacrylate, polymethyl acrylate, and cellulose, photoconductive polymers such as poly-N-vinylcarbazole and polysilane, and conductive polymers such as polythiophene and polypyrrole. Examples of the additive include an antioxidant, a UV absorbing agent, and a plasticizer. In the case of wet system film formation, since the affinity between each of the compounds is good, even a compound that on its own is highly aggregated and tends to form a nonuniform film can give a good film by mixing it with a derivative having low aggregation.

In order to improve the stability of the organic EL device thus obtained to temperature, humidity, the atmosphere, etc., it is also preferable to form a protective layer on the surface of the device or coat the entire device with a silicone oil, a polymer, etc.

As hereinbefore described, the organic EL device obtained using Composition X or Composition Y can emit yellow to red light, improve characteristics such as the luminescence efficiency and the maximum luminance, and has a long lifetime. This organic EL device can give a practical level of luminance with a low drive voltage, and the problem of degradation, which up till now has been serious, can be suppressed. This organic EL device can therefore preferably be used as a flat panel display of a wall-mounted television, etc. or a flat luminescent material and, furthermore, it can find application as the light source of a photocopier, a printer, etc., the light source of a liquid crystal display, an instrument, etc., a display board, a signal lamp, etc.

The present invention is explained in detail below by means of Examples, but the present invention is not limited to the Examples below. In the Examples, the mixing ratios are all expressed as a ratio by weight unless otherwise specified. Vapor deposition (vacuum vapor deposition) was carried out under a vacuum of 10⁻⁶ Torr without temperature control such as heating, cooling of a substrate, etc. When evaluating the light-emitting characteristics of the devices, the characteristics of an organic EL device having 2 mm x 2 mm electrodes were measured. The measurement was carried out while increasing the voltage by 1 V at a time, and the current, the luminance, and the chromaticity at each voltage were recorded. The maximum luminance and the efficiency are maximum values among the measured values at each of the voltages, and the voltage varied according to the device. The CIE chromaticity (x value) is a value measured at a given point in the range of luminance of 100 to 500 (cd/m²) unless otherwise specified. In the description below, 'short wavelength area' denotes the area of a portion at 600 nm or shorter in the 500-800 nm region of the luminescence spectrum.

### [Example 1]

Compound (A7) in Table 1, Compound (B17) in Table 2, 2,5-bis(1-naphthyl)-1,3,4-oxadiazole, and a polycarbonate resin (Teijin Chemicals Ltd.: Panlite K-1300) were dissolved in tetrahydrofuran at a ratio of 1:0.1:2:10, and this solution was used to form a light-emitting layer at a film thickness of 100 nm on a cleaned glass plate having an ITO electrode (anode) by a spin coating method. A magnesium and silver alloy (mixing ratio 10:1) was vapor-deposited thereon to form an electrode (cathode) at a film thickness of 150 nm, and an organic EL device (one layer type) was thus obtained.

This device gave a red luminescence with a luminance of 150 (cd/m²) at a dc voltage of 5 V, a maximum luminance of 860 (cd/m²), and a luminescence efficiency of 0.78 (lm/W).

### [Example 2]

N,N'-(3-Methylphenyl)-N,N'-diphanyl-1,1'-biphenyl-4,4'-diamine (TPD) and polyvinylcarbazole (PVK) were dissolved in 1,2-dichloroethane at a ratio of 1:1, and this solution was used to form a hole injection layer at a film thickness of 50 nm on a cleaned glass plate having an ITO electrode by a spin coating method. On the top of the hole injection layer thus obtained, Compound (C1) below: 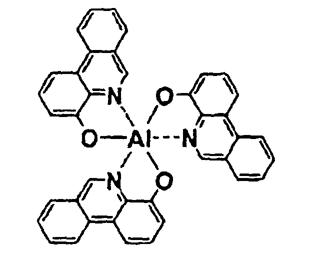 and Compound (B42) in Table 2 were vapor-codeposited at a ratio of 95:5 to give an electron injection type light-emitting layer having a film thickness of 60 nm. On the top thereof, a magnesium and silver alloy (mixing ratio 10:1) was vapor-deposited to form an electrode having a film thickness of 100 nm, and an organic EL device (two layer type) was thus obtained.

This device gave a red luminescence with a luminance of 1300 (cd/m²) at a dc voltage of 5 V, a maximum luminance of 18000 (cd/m²), a luminescence efficiency of 1.7 (lm/W), and a value of x in the CIE chromaticity diagram of 0.62.

The peak wavelength of the fluorescence spectrum of a solid film (film thickness 60 nm) of Compound (C1) was 560 nm, and the short wavelength area of the fluorescence spectrum of a solid film (film thickness 60 nm) of Compound (C1) containing 5 wt % of Compound (B42) was 8%.

### [Example 3]

TPD and polyvinylcarbazole (PVK) were dissolved in 1,2-dichloroethane at a ratio of 1:1, and this solution was used to form a hole injection layer at a film thickness of 50 nm on a cleaned glass plate having an ITO electrode by a spin coating method. On the top of the hole injection layer thus obtained, Compound (C2) below: 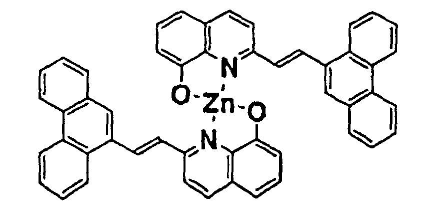 and DCJTB (D1) having the structure below: 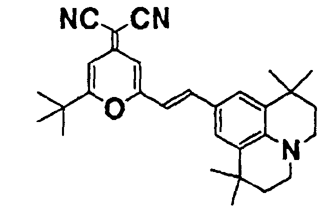 were vapor-codeposited at a ratio of 97:3 to give an electron injection type light-emitting layer having a film thickness of 60 nm. On the top thereof, a magnesium and silver alloy (mixing ratio 10:1) was vapor-deposited to form an electrode having a film thickness of 100 nm, and an organic EL device (two layer type) was thus obtained.

This device gave a red luminescence with a luminance of 500 (cd/m²) at a dc voltage of 5 V, a maximum luminance of 9200 (cd/m²), a luminescence efficiency of 1.3 (lm/W), and x = 0.64.

The peak wavelength of the fluorescence spectrum of a solid film (film thickness 60 nm) of Compound (C2) was 590 nm, and the short wavelength area of the fluorescence spectrum of a solid film (film thickness 60 nm) of Compound (C2) containing 5 wt % of Compound (D1) was 3.2 %. The short wavelength area of the EL emission spectrum of the device thus obtained was 3.5%.

### [Example 4]

Compound (A22) in Table 1 and Compound (B10) in Table 2 were dissolved in methylene chloride at a ratio of 93:7, and this solution was used to form a hole injection type light-emitting layer at a film thickness of 50 nm on a cleaned glass plate having an ITO electrode by a spin coating method. On the top of the hole injection type light-emitting layer thus obtained, bis(2-methyl-8-hydroxyquinolinate)(1-naphthalate) gallium complex was vapor-deposited to give an electron injection layer having a film thickness of 40 nm, on the top thereof a magnesium and silver alloy (mixing ratio 10:1) was vapor-deposited to form an electrode having a film thickness of 100 nm, and an organic EL device (two layer type) was thus obtained.

This device gave a red luminescence with a luminance of 2200 (cd/m²) at a dc voltage of 5 V, a maximum luminance of 15600 (cd/m²), a luminescence efficiency of 2.3 (lm/W), and x = 0.61.

The peak wavelength of the fluorescence spectrum of a solid film (film thickness 50 nm) of Compound (A22) was 560 nm, and the short wavelength area of the fluorescence spectrum of a solid film (film thickness 50 nm) of Compound (A22) containing 5 wt % of Compound (B10) was 13 %. The short wavelength area of the EL emission spectrum of the device thus obtained was 16%.

### [Example 5]

Compound (A19) in Table 1 and Compound (D2) below: 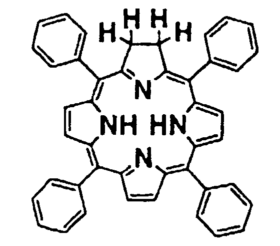 were vapor-codeposited on a cleaned glass plate having an ITO electrode at a ratio of 99:1 to give a hole injection type light-emitting layer having a film thickness of 50 nm. Bis(2-methyl-8-hydroxyquinolinate)(*p*-cyanophenolate) gallium complex was then vapor-deposited on the top of the hole injection type light-emitting layer to form an electron injection layer having a film thickness of 30 nm, on the top thereof a magnesium and silver alloy (mixing ratio 10:1) was vapor-deposited to form an electrode having a film thickness of 100 nm, and an organic EL device (two layer type) was thus obtained.

This device gave a red luminescence with a luminance of 430 (cd/m²) at a dc voltage of 5 V, a maximum luminance of 23400 (cd/m²), a luminescence efficiency of 2.4 (lm/W), and an x value of 0.68.

The peak wavelength of the fluorescence spectrum of a solid film (film thickness 50 nm) of Compound (A19) was 630 nm. The area at 600 nm or shorter was hardly present in the fluorescence spectrum of a solid film (film thickness 50 nm) of Compound (A19) containing 5 wt % of Compound (D2) or in the EL emission spectrum of the device so obtained.

### [Example 6]

TPD was vapor-deposited on a cleaned glass plate having an ITO electrode to give a hole injection layer having a film thickness of 20 nm. On the top of the hole injection layer thus obtained Compound (A36) in Table 1 and Compound (B46) in Table 2 were then vapor-codeposited at a ratio of 9:1 to give a light-emitting layer having a film thickness of 40 nm, and on the top of the light-emitting layer thus obtained Alq3 was vapor-deposited to give an electron injection layer having a film thickness of 30 nm. On the top thereof, a magnesium and silver alloy (mixing ratio 10:1) was vapor-deposited to give an electrode having a film thickness of 200 nm, and an organic EL device (three layer type) was thus obtained.

This device gave a red luminescence with a luminance of 5100 (cd/m²) at a dc voltage of 5 V. The half-life when driven with a constant current at a luminance of 500 (cd/m²) was 3000 hours.

### [Comparative Example 1]

An organic EL device was fabricated using the same materials and under the same conditions as to vapor-codeposition ratio, film thickness, etc. as in Example 6 except that N,N,N',N'-tetrakis[*p*-(α,α-dimethylbenzyl)phenyl]-9,10-anthracenediamine (R1) (solid film fluorescence peak wavelength: 530 nm) was used instead of Compound (A36).

The luminance of luminescence given by this device at a dc voltage of 5 V was 2600 (cd/m²), and the color of the luminescence was orange. The half-life when driven with a constant current at a luminance of 500 (cd/m²) was 400 hours, and the color changed to yellow over time.

### [Example 7]

TPD was vacuum vapor-deposited on a cleaned glass plate having an ITO electrode to give a hole injection layer having a film thickness of 40 nm. On the top of the hole injection layer thus obtained, Compound (A16) in Table 1 and rubrene (C3) having the structure below: 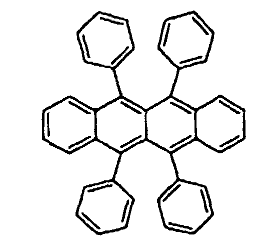 were vapor-codeposited at a ratio of 4:6 to give a light-emitting layer having a film thickness of 30 nm, and on the top thereof Alq3 was vapor-deposited to give an electron injection layer having a film thickness of 30 nm. On the top of the electron injection layer thus obtained, a magnesium and silver alloy (mixing ratio 10:1) was vapor-deposited to give an electrode having a film thickness of 200 nm, and an organic EL device (three layer type) was thus obtained.

This device gave a red luminescence with a luminance of 3700 (cd/m²) at a dc voltage of 5 V, a maximum luminance of 49000 (cd/m²), and x = 0.63. The half-life when driven with a constant current at a luminance of 500 (cd/m²) was 1500 hours.

The peak wavelength of the fluorescence spectrum of a solid film (film thickness 30 nm) of rubrene (C3) was 570 nm, and the short wavelength area of the fluorescence spectrum of a solid film (film thickness 30 nm) of Compound (C3) containing 5 wt % of Compound (A16) was 5 %. The short wavelength area of the EL emission spectrum of the device thus obtained was 4.5%.

### [Comparative Example 2]

An organic EL device was fabricated using the same materials and under the same conditions as to vapor-codeposition ratio, film thickness, etc. as in Example 7 except that Compound (D1) was used instead of Compound (A16), and Alq3 (R2) (solid film fluorescence peak wavelength: 520 nm) was used instead of Compound (C3).

This device gave a reddish orange luminescence with a maximum luminance of 15000 (cd/m²) and x = 0.60 (at a luminance of 500 cd/m²) and the color changed to yellow at increased luminance. The half-life when driven with a constant current at a luminance of 500 (cd/m²) was 280 hours.

### [Examples 8 to 44]

4,4'-Bis[N-(1-naphthyl)-N-phenylamino]biphenyl (α-NPD) was vapor-deposited on a cleaned glass plate having an ITO electrode to give a hole injection layer having a film thickness of 30 nm. On the top of the hole injection layer thus formed, the compounds shown in Table 3 were vapor-codeposited at the ratios shown in the table to give light-emitting layers having a film thickness of 30 nm. On the top thereof bis(2-methyl-5-phenyl-8-hydroxyquinolinate) (phenolate) gallium complex was vapor-deposited to give an electron injection layer having a film thickness of 30 nm, on the top thereof a magnesium and silver alloy (mixing ratio 10:1) was vapor-deposited to give an electrode having a film thickness of 100 nm, and organic EL devices (three layer type) were thus obtained.

The luminescence characteristics of the devices thus obtained are given in Table 3. In the table, 'luminance' denotes a value when 5 V dc was applied. All of the organic EL devices of these Examples gave a yellow to red luminescence having high luminance characteristics of a maximum luminance of 30000 (cd/m²) or higher.

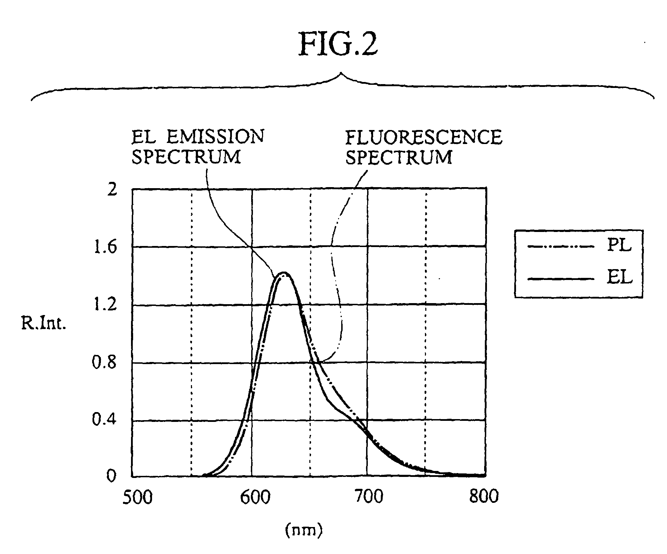

The fluorescence spectrum of a solid film (film thickness 30 nm) of Compound (A4) containing 5 wt % of Compound (B9) used in Example 8 and the EL emission spectrum of the device of Example 8 are shown in Fig. 2. The peak wavelength of the fluorescence spectra of solid films (film thickness 30 nm) of the Compounds (A) used in the Examples in Table 3 and the proportion of the short wavelength area of the fluorescence spectra of solid films (film thickness 30 nm) of Compound (A4) containing 5 wt % of Compound (B) are shown in Table 4. Those that are not given in this table gave a yellow to yellowish orange EL emission, and they are not included in the combination of Compounds (C) and (D) of the present invention, but they are examples showing good characteristics as a combination of Compounds (A) and (B).

**[Table 3]**

| Example | Compound | | Ratio A : B | Luminance (cd/m²) | Maximum luminance (cd/m²) | Maximum luminescence efficiency (lm/W) |
|---|---|---|---|---|---|---|
| | A | B | | | | |
| 8 | (A4) | (B9) | 95 : 5 | 4210 | 34100 | 3.4 |
| 9 | (A3) | (B2) | 99 : 1 | 5450 | 45300 | 4.7 |
| 10 | (A6) | (B8) | 97 : 3 | 4890 | 38900 | 4.2 |
| 11 | (A9) | (B16) | 93 : 7 | 3630 | 32000 | 2.9 |
| 12 | (A12) | (B21) | 90 : 10 | 2200 | 35200 | 3.1 |
| 13 | (A14) | (B24) | 85 : 15 | 1900 | 33300 | 2.8 |
| 14 | (A15) | (B26) | 98 : 2 | 5250 | 49800 | 5.2 |
| 15 | (A16) | (B28) | 80 : 20 | 2000 | 30500 | 2.5 |
| 16 | (A18) | (B32) | 96 : 4 | 4230 | 44400 | 4.9 |
| 17 | (A22) | (B34) | 99 : 1 | 5980 | 52800 | 6.2 |
| 18 | (A24) | (B35) | 98 : 2 | 4990 | 55000 | 5.1 |
| 19 | (A25) | (B39) | 95 : 5 | 4110 | 50200 | 4.4 |
| 20 | (A26) | (B42) | 97 : 3 | 3890 | 47700 | 4.9 |
| 21 | (A27) | (B43) | 92 : 8 | 3100 | 36500 | 3.3 |
| 22 | (A29) | (B46) | 95 : 5 | 3420 | 41600 | 3.6 |
| 23 | (A32) | (B50) | 60 : 40 | 1200 | 48700 | 3.4 |
| 24 | (A34) | (B52) | 94 : 6 | 2800 | 31800 | 3.2 |
| 25 | (A35) | (B54) | 97 : 3 | 3840 | 46200 | 4.0 |
| 26 | (A38) | (B55) | 99 : 1 | 4740 | 45600 | 5.4 |
| 27 | (A43) | (B56) | 98 : 2 | 4420 | 50500 | 4.8 |
| 28 | (A48) | (B58) | 95 : 5 | 2580 | 42900 | 5.0 |
| 29 | (A45) | (B60) | 95 : 5 | 3820 | 36700 | 3.7 |
| 30 | (A41) | (B62) | 97 : 3 | 4310 | 43800 | 4.5 |
| 31 | (A39) | (B67) | 99 : 1 | 6010 | 39900 | 4.2 |
| 32 | (A33) | (B41) | 97 : 3 | 4670 | 44600 | 4.3 |
| 33 | (A31) | (B37) | 90 : 10 | 4020 | 42300 | 3.5 |
| 34 | (A19) | (B4) | 10 : 90 | 2450 | 34700 | 2.8 |
| 35 | (A21) | (B27) | 95 : 5 | 2360 | 41800 | 3.9 |
| 36 | (A2) | (B14) | 99 : 1 | 5090 | 54200 | 5.8 |
| 37 | (A4) | (B69) | 95 : 5 | 3020 | 35100 | 3.4 |
| 38 | (A22) | (B70) | 93 : 7 | 4150 | 32400 | 3.1 |
| 39 | (A4) | (B71) | 90 : 10 | 2230 | 30900 | 2.9 |
| 40 | (A6) | (B72) | 85 : 15 | 5490 | 36000 | 2.6 |
| 41 | (A4) | (B73) | 95 : 5 | 2010 | 41100 | 4.9 |
| 42 | (A19) | (B74) | 97 : 3 | 5980 | 56700 | 6.0 |
| 43 | (A36) | (B75) | 92 : 8 | 4680 | 33100 | 3.5 |
| 44 | (A38) | (B76) | 90 : 10 | 2170 | 38700 | 3.7 |

**[Table 4]**

| Example | Compound A | Peak wavelength (nm) | Compound B | Area proportion (%) |
|---|---|---|---|---|
| 8 | (A4) | 560 | (B9) | 6 |
| 11 | (A9) | 600 | (B16) | 2 |
| 12 | (A12) | 570 | (B21) | 6 |
| 13 | (A14) | 560 | (B24) | 10 |
| 14 | (A15) | 650 | (B26) | 15 |
| 15 | (A16) | 660 | (B28) | 14 |
| 16 | (A18) | 630 | (B32) | 4 |
| 17 | (A22) | 560 | (B34) | 6 |
| 18 | (A24) | 590 | (B35) | 4.5 |
| 19 | (A25) | 580 | (B39) | 9 |
| 20 | (A26) | 570 | (B42) | 8 |
| 21 | (A27) | 550 | (B43) | 18 |
| 22 | (A29) | 590 | (B46) | 4 |
| 23 | (A32) | 600 | (B50) | 15 |
| 24 | (A34) | 610 | (B52) | 11 |
| 32 | (A33) | 650 | (B41) | 3.5 |
| 33 | (A31) | 610 | (B37) | 3 |
| 35 | (A21 ) | 620 | (B27) | 4 |
| 36 | (A2) | 550 | (B14) | 7 |
| 37 | (A4) | 560 | (B69) | 5 |
| 38 | (A22) | 560 | (B70) | 5 |
| 39 | (A4) | 560 | (B71) | 8 |
| 41 | (A4) | 560 | (B73) | 9 |
| 44 | (A38) | 590 | (B76) | 11 |

### [Comparative Example 3]

An organic EL device was fabricated using the same materials and under the same conditions as in Example 8 except that Alq3 was used instead of Compound (A4).

This device gave luminescence with a luminance of 280 (cd/m²) at a dc voltage of 5 V, a maximum luminance of 9800 (cd/m²), and a luminescence efficiency of 0.8 (lm/W). [Comparative Example 4]

An organic EL device was fabricated using the same materials and under the same conditions as in Example 8 except that Compound (A15) was used instead of Compound (B9).

This device gave luminescence with a luminance of 2920 (cd/m²) at a dc voltage of 5 V, a maximum luminance of 35000 (cd/m²), and a luminescence efficiency of 3.6 (lm/W), but the color of the luminescence was yellowish orange, and the value of x in the CIE chromaticity coordinates was 0.59.

### [Comparative Example 5]

An organic EL device was fabricated using the same materials and under the same conditions as in Example 8 except that Alq3 was used instead of Compound (A4) in Comparative Example 4.

This device gave a yellowish orange luminescence with a luminance of 1850 (cd/m²) at a dc voltage of 5 V, a maximum luminance of 38700 (cd/m²), a luminescence efficiency of 3.9 (lm/W), and x = 0.57.

The peak wavelength of the fluorescence spectrum of a solid film (film thickness 30 nm) of Compound (A4) containing 5 wt % of Compound (A15) used in Comparative Examples 4 and 5 was 640 nm, and that of Compound (B9) used in Example 8 was 630 nm, and when judging only from the peak wavelength, Compound (A15) would give a more red luminescence. However, since the spectrum of Compound (A15) spread toward the bottom and the short wavelength area was as large as 25%, the devices of Comparative Examples 4 and 5 gave a yellowish orange luminescence. Since the characteristics such as the luminance and the efficiency are excellent, they can be used adequately as yellowish orange devices, but as a red device for a full color display there are many short wavelength components and the color balance is not adequate.

### [Comparative Example 6]

An organic EL device was fabricated using the same materials and under the same conditions as in Example 8 except that Alq3 was used instead of Compound (A4), and Compound (D2) was used instead of Compound (B9).

This device gave luminescence with a luminance of 180 (cd/m²) at a dc voltage of 5 V, a maximum luminance of 18700 (cd/m²), a luminescence efficiency of 1.2 (lm/W), and x = 0.48. The EL emission spectrum thus obtained showed a sharp peak in the red region due to luminescence from Compound (D2) as well as a broad peak in the green region due to luminescence from Alq3. Because of this, the luminescence was whitish with very poor chromaticity.

### [Example 45]

α-NPD was vapor-deposited on a cleaned glass plate having an ITO electrode to give a hole injection layer having a film thickness of 20 nm. Compound (A25) and Compound (A46) in Table 1 were then vapor-codeposited at a ratio of 8:2 to give a light-emitting layer having a film thickness of 40 nm, and Alq3 was then vapor-deposited to give an electron injection layer having a film thickness of 30 nm. On the top thereof lithium fluoride (LiF) was vapor-deposited so as to give a film thickness of 0.5 nm, aluminium (Al) was vapor-deposited to give a film thickness of 200 nm to form an electrode, and an organic EL device (three layer type) was thus obtained.

This device gave a red luminescence with a luminance of 5800 (cd/m²) at a dc voltage of 5 V, a maximum luminance of 41200 (cd/m²), a luminescence efficiency of 4.5 (lm/W), and x = 0.65.

The peak wavelength of the fluorescence spectrum of a solid film (film thickness 40 nm) of Compound (A25) was 580 nm, and the short wavelength area of the fluorescence spectrum of a solid film (film thickness 50 nm) of Compound (A25) containing 5 wt % of Compound (A46) was 4.5%. The short wavelength area of the EL emission spectrum of the device thus obtained was 3%.

### [Example 46]

An organic EL device was fabricated using the same materials and under the same conditions as in Example 8 except that a thin film having a film thickness of 30 nm was provided as a light-emitting layer by vapor codeposition of Compound (B4) and Compound (B32) in Table 2 at a ratio of 95:5.

This device gave a red luminescence with a luminance of 1300 (cd/m²) at a dc voltage of 5 V. a maximum luminance of 34600 (cd/m²), a luminescence efficiency of 3.8 (lm/W), and x = 0.64.

The peak wavelength of the fluorescence spectrum of a solid film (film thickness 30 nm) of Compound (B4) was 580 nm, and the short wavelength area of the fluorescence spectrum of a solid film (film thickness 30 nm) of Compound (B4) containing 5 wt % of Compound (B32) was 4%. The short wavelength area of the EL emission spectrum of the device thus obtained was 4%.

### [Example 47]

An organic EL device was fabricated using the same materials and under the same conditions as in Example 8 except that a thin film having a film thickness of 30 nm was provided as a light-emitting layer by vapor codeposition of Compound (C1) above and Compound (B9) in Table 2 at a ratio of 98:2.

This device gave a red luminescence with a luminance of 3200 (cd/m²) at a dc voltage of 5 V, a maximum luminance of 28300 (cd/m²), a luminescence efficiency of 3.2 (lm/W), and x = 0.62.

The peak wavelength of the fluorescence spectrum of a solid film (film thickness 30 nm) of Compound (C1) was 560 nm, and the short wavelength area of the fluorescence spectrum of a solid film (film thickness 30 nm) of Compound (C1) containing 5 wt % of Compound (B9) was 5.5%. The short wavelength area of the EL emission spectrum of the device thus obtained was 7%.

### [Example 48]

An organic EL device was fabricated using the same materials and under the same conditions as in Example 8 except that a thin film having a film thickness of 30 nm was provided as a light-emitting layer by vapor codeposition of Compound (C2) above and Compound (B49) in Table 2 at a ratio of 9:1.

This device gave a red luminescence with a luminance of 1700 (cd/m²) at a dc voltage of 5 V, a maximum luminance of 51200 (cd/m²), a luminescence efficiency of 4.5 (lm/W), and x = 0.61.

The peak wavelength of the fluorescence spectrum of a solid film (film thickness 30 nm) of Compound (C2) was 590 nm, and the short wavelength area of the fluorescence spectrum of a solid film (film thickness 30 nm) of Compound (C2) containing 5 wt % of Compound (B49) was 9%. The short wavelength area of the EL emission spectrum of the device thus obtained was 12%.

### [Example 49]

An organic EL device was fabricated using the same materials and under the same conditions as in Example 8 except that a thin film having a film thickness of 30 nm was provided as a light-emitting layer by vapor codeposition of Compound (A15) in Table 1 and Compound (D3) below at a ratio of 98:2.

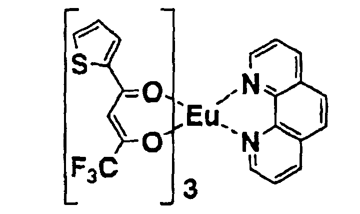

This device gave a red luminescence with a luminance of 4200 (cd/m²) at a dc voltage of 5 V, a maximum luminance of 32100 (cd/m²), and a luminescence efficiency of 3.1 (lm/W).

The peak wavelength of the fluorescence spectrum of a solid film (film thickness 30 nm) of Compound (A15) was 650 nm. The fluorescence spectrum of a solid film (film thickness 30 nm) of Compound (A15) containing 5 wt % of Compound (D3) and the EL emission spectrum of the device thus obtained had hardly any area at 600 nm or shorter.

### [Example 50]

An organic EL device was fabricated using the same materials and under the same conditions as in Example 8 except that a thin film having a film thickness of 30 nm was provided as a light-emitting layer by vapor codeposition of Compound (A2) in Table 1 and Compound (D1) above at a ratio of 95:5.

This device gave a red luminescence with a luminance of 2400 (cd/m²) at a dc voltage of 5 V, a maximum luminance of 17800 (cd/m²), and a luminescence efficiency of 2.2 (lm/W).

The peak wavelength of the fluorescence spectrum of a solid film (film thickness 30 nm) of Compound (A2) was 550 nm, and the short wavelength area of the fluorescence spectrum of a solid film (film thickness 30 nm) of Compound (A2) containing 5 wt % of Compound (D1) was 8%. The short wavelength area of the EL emission spectrum of the device thus obtained was 6%.

### [Example 51]

α-NPD was vapor-deposited on a cleaned glass plate having an ITO electrode to give a hole injection layer having a film thickness of 40 nm. N,N,N',N'-Tetra-*p*-biphenylyl-1,4-naphthalenediamine was then vapor-deposited to give a first light-emitting layer having a film thickness of 10 nm, Compound (A6) in Table 1 and Compound (B9) in Table 2 were vapor-codeposited at a ratio of 95:5 to give a second light-emitting layer having a film thickness of 30 nm, bis(2-methyl-8-hydroxyquinolinate)(phenolate) gallium complex was further vapor-deposited to give an electron injection layer having a film thickness of 30 nm, on the top thereof a magnesium and silver alloy (mixing ratio 10:1) was vapor-deposited to give an electrode having a film thickness of 100 nm, and an organic EL device (four layer type) was thus obtained.

This device gave a substantially white luminescence with a luminance of 5800 (cd/m²) at a dc voltage of 5 V, a maximum luminance of 35400 (cd/m²), and a luminescence efficiency of 3.7 (lm/W). This suggests that pale blue luminescence from the first light-emitting layer and red luminescence from the second light-emitting layer occurred simultaneously.

The peak wavelength of the fluorescence spectrum of a solid film (film thickness 30 nm) of Compound (A6) was 560 nm.

### [Example 52]

4,4',4''-Tris[N-(3-methylphenyl)-N-phenylamino] triphenylamine was vapor-deposited on a cleaned glass plate having an ITO electrode to give a first hole injection layer having a film thickness of 60 nm. α-NPD was then vapor-deposited to give a second hole injection layer having a film thickness of 20 nm. Subsequently, Compound (A13) in Table 1 and Compound (B12) in Table 2 were vapor-codeposited at a ratio of 92:8 to give a light-emitting layer having a film thickness of 10 nm, and Alq3 was further vacuum vapor-deposited to give an electron injection layer having a film thickness of 30 nm. On the top thereof. LiF was vapor-deposited to give a film thickness of 0.2 nm, A1 was then vapor-deposited to give a film thickness of 150 nm to form an electrode, and an organic EL device (four layer type) was thus obtained.

This device gave a red luminescence with a luminance of 6600 (cd/m²) at a dc voltage of 5 V, a maximum luminance of 36500 (cd/m²), and a luminescence efficiency of 4.1 (lm/W). The half-life when driven with a constant current at a luminance of 500 (cd/m²) was 2400 hours.

The peak wavelength of the fluorescence spectrum of a solid film (film thickness 50 nm) of Compound (A13) was 580 nm, and the short wavelength area of the fluorescence spectrum of a solid film (film thickness 50 nm) of Compound (A13) containing 5 wt % of Compound (B12) was 2%.

### [Example 53]

An organic EL device was fabricated using the same materials and under the same conditions as in Example 52 except that a thin film having a film thickness of 30 nm was provided as a first hole injection layer by vapor deposition of Compound (A18) in Table 1.

This device gave luminescence with a maximum luminance of 22300 (cd/m²) and a luminescence efficiency of 2.6 (lm/W). The half-life when driven with a constant current at a luminance of 500 (cd/m²) was 1800 hours.

### [Comparative Example 7]

An organic EL device was fabricated using the same materials and under the same conditions as in Example 52 except that α-NPD (solid film fluorescence peak wavelength: 440 nm) was used instead of Compound (A13).

This device gave luminescence with a maximum luminance of 12200 (cd/m²), and the half-life when driven with a constant current at a luminance of 500 (cd/m²) was 220 hours.

### [Example 54]

An organic EL device was fabricated using the same materials and under the same conditions as in Example 52 except that a hole injection layer having a film thickness of 20 nm was provided using copper phthalocyanine instead of 4,4',4''-tris[N-(3-methylphenyl)-N-phenylamino]triphenylamine.

This device gave luminescence with a maximum luminance of 32600 (cd/m²) and a luminescence efficiency of 3.8 (lm/W). The half-life when driven with a constant current at a luminance of 500 (cd/m²) was 1900 hours.

### [Comparative Example 8]

An organic EL device was fabricated using the same materials and under the same conditions as in Example 54 except that 4-(dicyanomethylene)-2-methyl-6-(*p*-dimethylaminostyryl)-4H-pyran (DCM) was used instead of Compound (B12).

The device gave a yellowish orange luminescence with a maximum luminance of 11200 (cd/m²), and the half-life when driven with a constant current at a luminance of 500 (cd/m²) was 320 hours.

The short wavelength area of the fluorescence spectrum of a solid film (film thickness 50 nm) of Compound (A13) containing 5 wt % of DCM was 30%.

### [Example 55]

TPD was vapor-deposited on a cleaned glass plate having an ITO electrode to give a hole injection layer having a film thickness of 20 nm. Compound (B2) and Compound (B70) in Table 2 were then vapor-codeposited at a ratio of 9:1 to give a light-emitting layer having a film thickness of 40 nm, and Alq3 was then vapor-deposited to give an electron injection layer having a film thickness of 30 nm. On the top thereof a magnesium and silver alloy (mixing ratio 10:1) was vapor-deposited to form an electrode having a film thickness of 200 nm, and an organic EL device (three layer type) was thus obtained.

This device gave a red luminescence with a luminance of 4900 (cd/m²) at a dc voltage of 5 V. The half-life when driven with a constant current at a luminance of 500 (cd/m²) was 3000 hours.

The peak wavelength of the fluorescence spectrum of a solid film (film thickness 40 nm) of Compound (B2) was 570 nm, and the short wavelength area of the fluorescence spectrum of a solid film (film thickness 40 nm) of Compound (B2) containing 5 wt % of Compound (B70) was 5%. The short wavelength area of the EL emission spectrum of the device thus obtained was 4%.

### [Example 56]

An organic EL device was fabricated using the same materials and under the same conditions as in Example 8 except that a thin film having a film thickness of 30 nm was provided as a light-emitting layer by vapor codeposition of Compound (A4) in Table 1 and Compound (B77) in Table 2 at a ratio of 95:5.

This device gave a red luminescence with a luminance of 4230 (cd/m²) at a dc voltage of 5 V, a maximum luminance of 45400 (cd/m²), a luminescence efficiency of 4.2 (lm/W), and x = 0.62.

The peak wavelength of the fluorescence spectrum of a solid film (film thickness 30 nm) of Compound (A4) was 560 nm, and the short wavelength area of the fluorescence spectrum of a solid film (film thickness 30 nm) of Compound (A4) containing 5 wt % of Compound (B81) was 6%. The short wavelength area of the EL emission spectrum of the device thus obtained was 5.5%.

### [Example 57]

An organic EL device was fabricated using the same materials and under the same conditions as in Example 8 except that a thin film having a film thickness of 30 nm was provided as a light-emitting layer by vapor codeposition of Compound (A4) in Table 1 and Compound (B81) in Table 2 at a ratio of 95:5.

This device gave a red luminescence with a luminance of 5860 (cd/m²) at a dc voltage of 5 V, a maximum luminance of 52200 (cd/m²), a luminescence efficiency of 5.9 (lm/W), and x = 0.62.

The short wavelength area of the fluorescence spectrum of a solid film (film thickness 30 nm) of Compound (A4) containing 5 wt % of Compound (B81) was 7%. The short wavelength area of the EL emission spectrum of the device thus obtained was 7.5%. [Example 58]

An organic EL device was fabricated using the same materials and under the same conditions as in Example 8 except that a thin film having a film thickness of 30 nm was provided as a light-emitting layer by vapor codeposition of Compound (A22) in Table 1 and Compound (B83) in Table 2 at a ratio of 97:3.

This device gave a red luminescence with a luminance of 3300 (cd/m²) at a dc voltage of 5 V, a maximum luminance of 61600 (cd/m²), a luminescence efficiency of 6.5 (lm/W), and x = 0.62.

The short wavelength area of the fluorescence spectrum of a solid film (film thickness 30 nm) of Compound (A22) containing 5 wt % of Compound (B83) was 6%. The short wavelength area of the EL emission spectrum of the device thus obtained was 7%.

### [Example 59]

An organic EL device was fabricated using the same materials and under the same conditions as in Example 52 except that a thin film having a film thickness of 20 nm was provided as a light-emitting layer by vapor codeposition of Compound (A49) in Table 1 and Compound (B9) in Table 2 at a ratio of 97:3.

This device gave red luminescence with a luminance of 2500 (cd/m²) at a dc voltage of 5 V, a maximum luminance of 34500 (cd/m²), a luminescence efficiency of 4.0 (lm/W), and x = 0.63.

The peak wavelength of the fluorescence spectrum of a solid film (film thickness 20 nm) of Compound (A49) was 560 nm, and the short wavelength area of the fluorescence spectrum of a solid film (film thickness 20 nm) of Compound (A49) containing 5 wt % of Compound (B9) was 5%. The short wavelength area of the EL emission spectrum of the device thus obtained was 4%.

### [Examples 60 to 74]

Organic EL devices were fabricated by the same method as in Example 8 except that a thin film having a film thickness of 30 nm was provided as a light-emitting layer by vapor codeposition of the combinations shown in Table 5.

The luminescence characteristics of the devices thus obtained are given in Table 5. In the table, 'luminance' denotes a value when 5 V dc was applied. All of the organic EL devices of these Examples gave a red luminescence having high luminance characteristics of a maximum luminance of 30000 (cd/m²) or higher.

The peak wavelength of the fluorescence spectra of solid films (film thickness 30 nm) of the Compounds (C) used in the Examples in Table 5 and the short wavelength area of the fluorescence spectra of solid films (film thickness 30 nm) of Compound (A4) containing 5 wt % of Compound (D) are given in Table 6.

**[Table 5]**

| Example | Compound | | Ratio C: D | Luminance (cd/m²) | Maximum luminance (cd/m²) | Maximum luminescence efficiency (lm/W) |
|---|---|---|---|---|---|---|
| | C(orA) | D(or B) | | | | |
| 60 | (A49) | (B69) | 97 : 3 | 3420 | 38600 | 4.2 |
| 61 | (A50) | (B81) | 93 : 7 | 5230 | 48200 | 4.9 |
| 62 | (A54) | (B9) | 95 : 5 | 4200 | 42200 | 4.1 |
| 63 | (A60) | (B73) | 98 : 2 | 6900 | 58300 | 5.8 |
| 64 | (A63) | (B77) | 85 : 15 | 2650 | 32800 | 3.2 |
| 65 | (A84) | (B83) | 80 : 20 | 2000 | 30500 | 3.5 |
| 66 | (A90) | (B70) | 96 : 4 | 5250 | 62400 | 5.9 |
| 67 | (A95) | (837) | 99 : 1 | 5960 | 38800 | 3.4 |
| 68 | (A97) | (B10) | 98 : 2 | 5290 | 54600 | 5.1 |
| 69 | (A30) | (A33) | 95 : 5 | 2160 | 40400 | 4.4 |
| 70 | (A75) | (A48) | 97 : 3 | 5890 | 41700 | 4.3 |
| 71 | (B6) | (A94) | 92:8 | 3100 | 49500 | 4.8 |
| 72 | (B8) | (A96) | 95 : 5 | 2460 | 31600 | 3.3 |
| 73 | (B3) | (B9) | 60:40 | 3500 | 38700 | 3.4 |
| 74 | (85) | (B81) | 94 : 6 | 4400 | 51800 | 5.2 |

**[Table 6]**

| Example | Compound C | Peak wavelength (nm) | Compound D | Area proportion (%) |
|---|---|---|---|---|
| 60 | (A49) | 560 | (B69) | 5 |
| 61 | (A50) | 550 | (B81) | 7 |
| 62 | (A54) | 590 | (B9) | 6 |
| 63 | (A60) | 570 | (B73) | 9 |
| 64 | (A63) | 550 | (B77) | 6 |
| 65 | (A84) | 600 | (B83) | 6 |
| 66 | (A90) | 580 | (B70) | 5 |
| 67 | (A95) | 610 | (B37) | 3 |
| 68 | (A97) | 620 | (B10) | 12 |
| 69 | (A30) | 600 | (A33) | 10 |
| 70 | (A75) | 550 | (A48) | 15 |
| 71 | (B6) | 590 | (A94) | 17 |
| 72 | (B8) | 570 | (A96) | 7 |
| 73 | (B3) | 560 | (B9) | 6 |
| 74 | (B5) | 550 | (B81) | 7 |

As is clear from the above-mentioned Examples, the organic EL devices obtained have improved luminescence efficiency and luminance and have achieved a long lifetime, and the luminescent material, the doping material, the hole injecting material, the electron injecting material, the sensitizer, the resin, the electrode material, etc. used in combination and the device fabrication method are not limited.

The disclosure of the present application relates to subject matter described in Japanese Patent Application No. 2001-368036 filed on December 3, 2001 and Japanese Patent Application No. 2002-18009 filed on January 28, 2002, the contents of the disclosures therein being incorporated herein by reference.

It should be noted that, in addition to those described above, the above-mentioned embodiments can be modified and changed in various ways without departing from the novel and advantageous features of the present invention. Therefore, all such modifications and changes are intended to be included in the appended claims.

## Claims

1. An organic electroluminescent device composition comprising a compound (A) having a perylene ring and a compound (B) having a diketopyrrolopyrrole skeleton.

2. The organic electroluminescent device composition according to Claim 1, wherein the peak wavelength of the fluorescence spectrum of a solid film of the compound (A) is 550 nm or longer.

3. The organic electroluminescent device composition according to Claim 1 or 2, wherein the Compound (A) is a compound having on the perylene ring a substituted or unsubstituted amino group as a substituent.

4. The organic electroluminescent device composition according to Claim 3, wherein the Compound (A) is a compound having on the perylene ring 2 to 4 substituted or unsubstituted amino groups as substituents.

5. The organic electroluminescent device composition according to Claim 3, wherein the Compound (A) is a compound having on the perylene ring only one substituted or unsubstituted amino group as a substituent.

6. The organic electroluminescent device composition according to any one of Claims 3 to 5, wherein the amino group is a diarylamino group.

7. The organic electroluminescent device composition according to any one of Claims 1 to 6, wherein the Compound (B) is a compound that exhibits red fluorescence.

8. The organic electroluminescent device composition according to any one of Claims 1 to 7, wherein the Compound (B) is a diamine compound having a diketopyrrolopyrrole skeleton represented by general formula [I] below 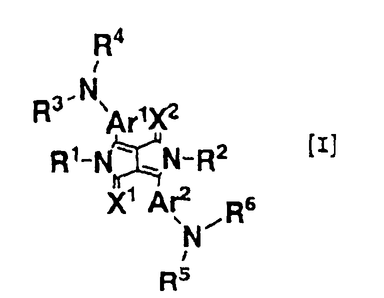 (in the formula, R¹ to R6 independently denote a hydrogen atom or a substituted or unsubstituted alkyl or aryl group (which may have a heteroatom in the ring); Ar¹ and Ar² independently denote a substituted or unsubstituted aryl group (which may have a heteroatom in the ring); and X¹ and X² independently denote O, S, Se, NE¹, or CE²E³, E¹ denotes an electron-withdrawing group, and E² and E³ denote hydrogen atoms or substituents, at least one thereof denoting an electron-withdrawing group).

9. The organic electroluminescent device composition according to any one of Claims 1 to 8, wherein, relative to the total content of the Compound (A) and the Compound (B), the content of the Compound (A) is 50 to 99.999 wt %, and the content of the Compound (B) is 0.001 to 50 wt %.

10. An organic electroluminescent device composition comprising a Compound (C) and a Compound (D) having the following characteristics:
(1) Compound (C): a compound having, as a solid film, a fluorescence spectrum peak wavelength of 550 nm or longer;
(2) Compound (D) : a compound having, as a solid film in which Compound (D) is contained at 5 wt% in Compound (C), an area at a wavelength of 600 nm or shorter in the fluorescence spectrum region of 500 to 800 nm of 20% or less of the entire area.

11. The organic electroluminescent device composition according to Claim 10, wherein the Compound (D) is a compound for which the area is at most 5% of the entire area.

12. The organic electroluminescent device composition according to Claim 10 or 11, wherein, relative to the total content of the Compound (C) and the Compound (D), the content of the Compound (C) is 50 to 99.999 wt %, and the content of the Compound (D) is 0.001 to 50 wt %.

13. The organic electroluminescent device composition according to any one of Claims 10 to 12, wherein at least one of the Compound (C) and the Compound (D) is a Compound (A) having a perylene ring.

14. The organic electroluminescent device composition according to Claim 13, wherein the Compound (A) is a compound having on the perylene ring a substituted or unsubstituted amino group as a substituent.

15. The organic electroluminescent device composition according to any one of Claims 10 to 14, wherein at least one of the Compound (C) and the Compound (D) is a Compound (B) having a diketopyrrolopyrrole skeleton.

16. An organic electroluminescent device comprising a pair of electrodes comprising an anode and a cathode, and one or more organic layers including a light-emitting layer formed between the electrodes, wherein at least one of the organic layers is a layer formed from the organic electroluminescent device composition according to any one of Claims 1 to 9.

17. The organic electroluminescent device according to Claim 16, wherein the layer including the organic electroluminescent device composition is the light-emitting layer.

18. An organic electroluminescent device comprising a pair of electrodes comprising an anode and a cathode, and one or more light-emitting layers formed between the electrodes, wherein at least one of the light-emitting layers is a layer formed from the organic electroluminescent device composition according to any one of Claims 10 to 15.

19. The organic electroluminescent device according to any one of Claims 16 to 18, wherein it further comprises at least one electron injection layer formed between the cathode and the light-emitting layer.

20. The organic electroluminescent device according to any one of Claims 16 to 19, wherein it further comprises at least one hole injection layer formed between the anode and the light-emitting layer.
